(19) Europäisches Patentamt
European Patent Office
Office européen des brevets

(11) **EP 2 270 077 A1**

(12) **EUROPEAN PATENT APPLICATION**
published in accordance with Art. 153(4) EPC

(43) Date of publication:
**05.01.2011 Bulletin 2011/01**

(21) Application number: **09730397.8**

(22) Date of filing: **27.03.2009**

(51) Int Cl.:
*C08J 5/18* (2006.01)        *C08J 7/00* (2006.01)
*C08K 5/00* (2006.01)        *C08L 23/04* (2006.01)
*H01L 23/29* (2006.01)       *H01L 23/31* (2006.01)
*H01L 31/04* (2006.01)

(86) International application number:
**PCT/JP2009/056342**

(87) International publication number:
**WO 2009/125685 (15.10.2009 Gazette 2009/42)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **09.04.2008 JP 2008101116**
**03.07.2008 JP 2008174366**
**02.09.2008 JP 2008224913**

(71) Applicant: **Asahi Kasei E-materials Corporation Tokyo 101-8101 (JP)**

(72) Inventors:
• **KAWASHIMA, Masahiko Tokyo 101-8101 (JP)**

• **KANAO, Masaaki Tokyo 101-8101 (JP)**
• **MATSUKI, Yutaka Tokyo 101-8101 (JP)**
• **MASAKI, Daisuke Tokyo 101-8101 (JP)**
• **KOYANO, Toshihiro Tokyo 101-8101 (JP)**

(74) Representative: **Bradley, Josephine Mary D Young & Co LLP 120 Holborn London EC1N 2DY (GB)**

(54) **SEALING RESIN SHEET**

(57) Disclosed is a sealing resin sheet for allowing a resin layer in a softened state to adhere to and seal a material to be sealed, wherein the resin layer comprises an adhesive resin.

EP 2 270 077 A1

## Description

Technical Field

The present invention relates to a sealing resin sheet suitably used in solar cell modules, composite materials, and the like.

Background Art

In recent years, worldwide global warming has increased awareness about the environment, resulting in the spotlight centering on new energy systems producing no greenhouse gases such as carbon dioxide. Electric power generation by solar cells provides energy without releasing any gas causing the warming including carbon dioxide; thus, this energy is researched and developed as a clean energy and has received attention as an industrial energy.

Representative examples of the solar cell include those using single-crystal and polycrystal silicon cells (crystalline-based silicon cells) and those using an amorphous silicon and a compound semiconductor (thin film-based cells). Solar cells are often used under exposure to weather outdoors for extended periods of time; thus, the power generation portion has been modularized by bonding glass plates, backsheets, or the like together to prevent the entry of water from the outside to provide the protection of the power generation, the prevention of electrical leak, and the like.

In a member protecting the power generation portion, a transparent glass or a transparent resin is used on the side of optical incidence to ensure light transmission necessary for the power generation. In a member on the opposing side, aluminum foil, polyvinyl fluoride (PVF), polyethylene terephthalate (PET), or a laminated sheet barrier-coated with silica or the like thereof, which is called a backsheet, is used. A power generation element is put between sealing resin sheets, the outside of which is further coated with a glass or a backsheet and heat-treated to melt the sealing resin sheets to unify and seal (modularize) all of these.

The above-described sealing resin sheet is required to have the following (1) to (3) characteristics: (1) good adhesion to a glass, a power generation element, and a backsheet, (2) properties preventing the flow of a power generation element due to the melting of the sealing resin sheet in a high temperature condition (creep resistance), and (3) such transparency that the incidence of sunlight is not inhibited.

From such a viewpoint, the sealing resin sheet is made by film formation using calendering or T-die casting after blending additives such as an ultraviolet absorber as a remedial measure for ultraviolet degradation, a coupling agent for improving adhesion to a glass, and an organic peroxide for cross-linking in an ethylene-vinyl acetate copolymer (hereinafter sometimes abbreviated as EVA).

In view of exposure to sunlight over a long period, various additives such as a light-resisting agent are further blended to prevent reduction in optical characteristics due to resin degradation. This maintains such transparency that the incidence of sunlight is not inhibited over a long period.

To make a form in which a solar cell is modularized using the sealing resin sheet as described above include, there is a method which involves piling up a glass/ the sealing resin sheet/a power generation element such as a crystalline-based silicon cell/ the sealing resin sheet/a backsheet in that order and melting, and bonding together, the sealing resin sheets with the glass side down using a dedicated solar cell vacuum laminator through a step of preheating at not less than the melt temperature of the resin (for EVA, in the temperature condition of 150°C) and a press step.

First, the resin in the sealing resin sheet is melted in the preheating step, and the sheet is allowed to adhere to the member contacting the melted resin and vacuum laminated thereon in the press step. In the lamination step, (i) a cross-linking agent (for example, an organic peroxide) contained in the sealing resin sheet is decomposed by heat to promote the cross-linking of EVA. (ii) A coupling agent contained in the sealing resin sheet covalently bonds with the member contacting therewith. This improves adhesion to each other, preventing the flow of the power generation portion due to the melting of the sealing resin sheet in a high temperature condition (creep resistance) and achieving excellent adhesion to the glass, power generation element and backsheet.

Patent Document 1 discloses a solar cell element sealing material comprising an ethylene copolymer subjected to electron irradiation. This sealing material is composed of an organic polymeric resin sealing sheet. The resin sealing sheet is obtained by blending a silane coupling agent, an antioxidant, a cross-linking auxiliary, an ultraviolet absorber, and a light stabilizer in a resin such as an ethylene-vinyl acetate copolymer (EVA), an ethylene-unsaturated carboxylic ester copolymer, and an ethylene-unsaturated carboxylic acid copolymer, which is then subjected to sheeting by a extrusion and subsequent electron irradiation. The resulting sheet is Vacuum-laminated on the power generation element and the backsheet at 150°C to provide a module.

Patent Document 2 discloses a solar cell module sealed with a transparent organic polymeric resin layer comprising EVA, an ethylene-methyl acrylate copolymer (EMA), or the like, wherein at least one of the organic polymeric resin layers is cross-linked with electron irradiation.

Patent Document 3 discloses a solar cell-sealing sheet comprising EVA in which a cross-linking agent and a silane coupling agent are blended, wherein the sheet is crosslinked with radiation until a certain gel fraction is achieved.
Patent Document 1: Japanese Patent Laid-Open No. 2001-119047
Patent Document 2: Japanese Patent Laid-Open No. 06-334207
Patent Document 3: Japanese Patent Laid-Open No. 08-283696

Disclosure of the Invention

Problems to be Solved by the Invention

However, although Patent Document 1 describes that a higher gel fraction provides more excellent heat resistance, the sealing resin sheet cannot positively seal irregularities of the solar cell glass itself and irregularities resulting from the thickness of the wiring and the power generation cell without producing any clearance, resulting in the lamination conditions being required to be altered. The lamination temperature is often required to be elevated by about 30˚C, which may excessively damage the power generation portion to reduce the power generation efficiency. The blending of the silane coupling agent in the sealing resin sheet may also produce resin degradation when it is used in the solar cell, which may damage the power generation portion or reduce the power generation efficiency owing to the peeling and coloration of the sealing resin sheet. For the handling of the sealing resin sheet, it is also necessary in the distribution and storage thereof to store the sheet in a cool, dark place subjected to environmental control under constant temperature and humidity and control the expiration date for use because the adhesion may be reduced owing to the reaction of the silanol group of the silane coupling agent with water or the like; there is a need for further improved storage and handling of the sealing resin sheet. In addition, because the whole sealing resin sheet is cross-linked, a crystalline-based or thin-film-based power generation portion and the like are difficult to peel when disposed, showing that they have the shortcoming of being poorly recyclable.
Patent Document 2 also discloses that the irradiation treatment conditions in Examples are an accelerating voltage of 300 to 500 kV and an irradiation dose of 300 kGy; these conditions considerably increase the gel fraction of the sealing resin sheet after irradiation treatment to 85% or more. A high gel fraction provides excellent creep resistance, but inhibits the flow of the sealing resin sheet; thus, because the electron irradiation treatment is carried out on the light acceptance surface, when the power generation portion is a single-crystal or polycrystal cell, electron rays cannot reach the back side of the silicon cell, producing a place in which the sealing resin sheet is not cross-linked. Thus, the sealing resin sheet in the module partially has an uneven gel fraction in a high temperature environment. This sometimes makes it impossible to retain the silicon cell stably, leaving a problem that the essential power generation portion flows. When the sealing resin sheet electron-irradiated under such irradiation conditions before vacuum lamination is used, it becomes difficult to positively seal irregularities of the solar cell glass, irregularities resulting from the thickness of the wiring and the power generation cell, and the like without producing any clearance (i.e., inferiority sometimes occurs in the property of filling-in clearance). To resolve this problem, the vacuum lamination using the sealing resin sheet after cross-linking is often carried out at a lamination temperature increased by about 30˚C. However, the lamination step at a high temperature may excessively damage the power generation portion and thereby pose problems such as reduced power generation efficiency.
In addition, for Patent Document 3, the sheet is sensitive to humidity and temperature because it has an organic peroxide and a silane coupling agent, and thus it is necessary to control the storage environment after preparing the sheet, leaving the problem of being complicated and costly. For example, it is essential to control the humidity of the silane coupling agent; because of the need for its storage in a dry state, in an environment of high humidity, the silane coupling agent is inactivated and cannot sufficiently contribute to improved adhesive strength. It is also essential to control the temperature of the organic peroxide; in a high temperature condition, the organic peroxide is cleaved to cross-link the resin, thus making the filling-in of clearance in the lamination insufficient. Typically, such control is for storage at low humidity and low temperature, and the storage period is short. Thus, there remains a problem that the inventory holding is difficult and the inventory control of the sheet is demanding.
An object of the present invention is to provide a sealing resin sheet suitably used as a sealer, particularly for protecting members of a solar cell, wherein the sheet is improved in durability without compromising transparency, adhesion and the property of filling-in clearance.

Means for Solving the Problems

As a result of intensive studies for solving the above-described problems, the present inventors have found that the problems can be solved by a sealing resin sheet for allowing a resin layer in a softened state to adhere to and seal a material to be sealed, wherein the resin layer comprises an adhesive resin. Thereby, the present invention is accomplished.

Thus, the present invention is as follows.

[1] A sealing resin sheet for allowing a resin layer in a softened state to adhere to and seal a material to be sealed, wherein the resin layer comprises an adhesive resin.

[2] The sealing resin sheet according to item [1] above, wherein the adhesive resin comprises at least one resin selected from the group consisting of an olefin-based copolymer having a hydroxyl group, a modified polyolefin terminal- or graft-modified with an acidic functional group, and an ethylene copolymer containing glycidyl methacrylate.

[3] The sealing resin sheet according to item [2] above, wherein the olefin-based copolymer having the hydroxyl group is a saponified ethylene-vinyl acetate copolymer and/or a saponified ethylene-vinyl acetate-acrylate ester copolymer.

[4] The sealing resin sheet according to item [2] or [3] above, wherein the modified polyolefin terminal- or graft-modified with the acidic functional group is a maleic modified polyolefin terminal- or graft-modified with maleic anhydride.

[5] The sealing resin sheet according to any of items [1] to [4] above, wherein the resin layer comprises at least one thermoplastic resin selected from the group consisting of an ethylene-vinyl acetate copolymer, an ethylene-aliphatic unsaturated carboxylic acid copolymer, an ethylene-aliphatic carboxylate ester copolymer, and a polyolefin-based resin.

[6] The sealing resin sheet according to any of items [1] to [5] above, wherein a content of the adhesive resin in the resin layer is 10 to 100% by mass.

[7] The sealing resin sheet according to any of items [1] to [6] above, wherein a content of the thermoplastic resin in the resin layer is 0 to 90% by mass.

[8] The sealing resin sheet according to any of items [1] to [7] above, wherein the sheet has a single layer structure consisting of only the resin layer comprising an adhesive resin.

[9] The sealing resin sheet according to item [8] above, wherein the resin layer has a gel fraction of 1 to 65% by mass.

[10] The sealing resin sheet according to item [8] or [9] above, wherein the resin layer has a graded cross-linked structure.

[11] The sealing resin sheet according to any of items [1] to [7] above, wherein the sheet has a multilayer structure of at least two layers comprising a surface layer and an internal layer laminated on the surface layer, wherein at least one of the surface layer is the resin layer comprising an adhesive resin.

[12] The sealing resin sheet according to item [11] above, wherein the at least one of the surface layer has a gel fraction of 1 to 65% by mass.

[13] The sealing resin sheet according to item [11] or [12] above, wherein the sheet has a moisture vapor transmission rate of 40 $g/m^2 \cdot day$ or less.

[14] The sealing resin sheet according to any of items [1] to [13] above, wherein the sheet is obtained by film formation using a ring die.

[15] The sealing resin sheet according to any of items [1] to [14] above, wherein the sheet is used as a sealer for protecting a member of a solar cell.

[16] The sealing resin sheet according to any of items [1] to [14] above, wherein the sheet is used as an interlayer of a laminated glass.

Advantages of the Invention

According to the present invention, a sealing resin sheet can be provided which is improved in durability without compromising transparency, adhesion and the property of filling-in clearance.

Best Mode for Carrying Out the Invention

A best mode for carrying out the present invention (hereinafter referred to as "the present embodiment") is described below in detail. In this respect, the present invention is not intended to be limited to the following embodiment, and various modifications can be made within the scope of the gist of the invention.

The sealing resin sheet according to the present embodiment is a sealing resin sheet for allowing a resin layer in a softened state to adhere to and seal a material to be sealed, wherein the resin layer comprises an adhesive resin.

The sealing resin sheet according to the present embodiment uses the softened state of the resin layer for sealing. The softened state of the resin can be created by directly giving heat energy thereto or by giving the vibration inherent in the resin to cause the resin itself to generate heat. As a method for giving energy to the resin, well-known methods can also be applied which include a method using indirect heat such as radiation heat or oscillation heat generation such as ultrasound heat generation, in addition to the method involving directly giving heat.

The sealing resin sheet according to the present embodiment may have a single layer structure or a multilayer structure; however, it is provided at least with the resin layer containing the adhesive resin on the side contacting the material to be sealed.

[Adhesive Resin]

Examples of the adhesive resin contained in the resin layer of the sealing resin sheet according to the present embodiment include at least one selected from the group consisting of an olefin-based copolymer having a hydroxyl group, a modified polyolefin terminal- or graft-modified with an acidic functional group, and an ethylene copolymer containing glycidyl methacrylate.

Examples of the olefin-based copolymer having the hydroxyl group include partially or completely saponified ethylene-vinyl acetate copolymers and partially or completely saponified ethylene-vinyl acetate-acrylate ester copolymers.

The percentage of the hydroxyl group in the olefin-based copolymer having the hydroxyl group is preferably 0.1% to 15% by mass, more preferably 0.1% to 10% by mass, still more preferably 0.1% to 7% by mass in the resin constituting the resin layer.

If the percentage of the hydroxyl group in the olefin-based copolymer having the hydroxyl group is 0.1% by mass or more in the resin constituting the resin layer, the adhesion will tend to be good; if the percentage is 15% by mass or less, the compatibility with the resin (EVA etc.) constituting the resin layer will tend to be good, and the risk at which the finally resulting sealing resin sheet is made opaque will reduce.

The percentage of the hydroxyl group can be calculated from the original olefin-based polymer resin, VA% (the copolymerization ratio of vinyl acetate as determined by NMR measurement) of the resin, the saponification degree, and the blending ratio in the resin layer of the olefin-based copolymer having the hydroxyl group.

When the olefin-based copolymer having the hydroxyl group is the saponified ethylene-vinyl acetate copolymer, the content of vinyl acetate in the ethylene-vinyl acetate copolymer before saponification is preferably 10 to 40% by mass, more preferably 13 to 35% by mass, still more preferably 15 to 30% by mass based on the whole copolymer in view of achieving good optical property, adhesion and flexibility. The saponification degree of the saponified ethylene-vinyl acetate copolymer is preferably 10 to 70%, more preferably 15 to 65%, still more preferably 20 to 60% in view of achieving good transparency and adhesion.

Examples of the saponification method include a method involving saponifying a pellet or powder of an ethylene-vinyl acetate copolymer using an alkali catalyst in a lower alcohol such as methanol and a method involving dissolving an ethylene-vinyl acetate copolymer in a solvent such as toluene, xylene, and hexane in advance and then saponifying the copolymer using a small amount of alcohol and an alkali catalyst. A monomer containing a functional group other than a hydroxyl group may also be graft-polymerized to the saponified copolymer.

The saponified ethylene-vinyl acetate copolymer, which has a hydroxyl group in the side chain, improves adhesion compared to the ethylene-vinyl acetate copolymer. The amount of the hydroxyl group (saponification degree) can also be adjusted to control transparency and adhesion.

Examples of the modified polyolefin terminal- or graft-modified with acidic functional groups include polyethylene-based resins or polypropylene-based resins terminal- or graft-modified with maleic anhydride or a compound having a polar group such as a nitro group, a hydroxyl group and a carboxy group. Among others, a maleic modified polyolefin terminal- or graft-modified with maleic anhydride is preferable in view of the stability of the polar group.

Here, the polyethylene-based resins and polypropylene-based resins may use the same as those listed later as polyolefin-based resins to be described below.

The ethylene copolymer containing glycidyl methacrylate refers to an ethylene copolymer and an ethylene terpolymer with glycidyl methacrylate, which has an epoxy group as a reaction site. Examples of the ethylene copolymer containing glycidyl methacrylate include ethylene-glycidyl methacrylate copolymers, ethylene-glycidyl methacrylate-vinyl acetate copolymers, and ethylene-glycidyl methacrylate-methyl acrylate copolymers. The above compounds can deliver stable adhesion because of the high reactivity of glycidyl methacrylate. And the above compounds have low glass transition temperature and tend to provide good flexibility.

[Resin Layer Comprising Adhesive Resin]

The resin layer comprising the adhesive resin (hereinafter also referred to as "adhesive resin layer") will now be described. The adhesive resin layer may consist of only the adhesive resin; however, it preferably further comprises at least one thermoplastic resin selected from the group consisting of an ethylene-vinyl acetate copolymer (EVA), an ethylene-aliphatic unsaturated carboxylic acid copolymer, an ethylene-aliphatic carboxylate ester copolymer, and a polyolefin-based resin in view of ensuring good transparency, flexibility, adhesion to a material to be attached, and handleability.

Here, the ethylene-vinyl acetate copolymer refers to a copolymer obtained by the copolymerization of ethylene monomer and vinyl acetate. The ethylene-aliphatic unsaturated carboxylic acid copolymer refers to a copolymer obtained by the copolymerization of ethylene monomer and at least one monomer selected from aliphatic unsaturated carboxylic acids. In addition, the ethylene-aliphatic unsaturated carboxylic ester copolymer refers to a copolymer obtained by the copolymerization of ethylene monomer and at least one monomer selected from aliphatic unsaturated carboxylic esters.

The above copolymerization may be carried out by a well-known method such as a high-pressure method and a fusion method, and may use a multisite catalyst, a single site catalyst, or the like as a catalyst for polymerization reaction. In the copolymers, a form in which monomers are bonded is not particularly limited; polymers having bonding forms such as random bonding and block bonding may be used. In view of optical characteristics, the copolymers are preferably copolymers obtained by polymerization by random bonding using the high-pressure method.

The ethylene-vinyl acetate copolymer preferably has a percentage of the vinyl acetate in all monomers constituting the copolymer of 10 to 40% by mass, more preferably 13 to 35% by mass, still more preferably 15 to 30% by mass in view of optical characteristics, adhesion, and flexibility. In view of the processability of the sealing resin sheet, the value of the melt flow rate (hereinafter also referred to as "MFR") thereof as determined according to JIS-K-7210 (190˚C, 2.16 kg) is preferably 0.3 g/10 min. to 30 g/10 min., more preferably 0.5 g/min. to 30 g/min., still more preferably 0.8 g/min. to 25 g/min..

Examples of the ethylene-aliphatic unsaturated carboxylic acid copolymers include ethylene-acrylic acid copolymers (hereinafter also abbreviated as "EAA") and ethylene-methacrylic acid copolymers (hereinafter also abbreviated as "EMAA"). Examples of the ethylene-aliphatic carboxylate ester copolymers include ethylene-acrylate ester copolymers and ethylene-methacrylate ester copolymers. Here, as the acrylate ester and methacrylate ester, esters from an alcohol having 1 to 8 carbons such as methanol and ethanol are suitably used.

These copolymers may be multicomponent copolymers obtained by copolymerizing three or more components of monomers. Examples of the multicomponent copolymers include copolymers obtained by copolymerizing at least three monomers selected from ethylene, aliphatic unsaturated carboxylic acids, and aliphatic unsaturated carboxylic esters.

The ethylene-aliphatic unsaturated carboxylic acid copolymer preferably has a percentage of the aliphatic unsaturated carboxylic acid in all monomers constituting the copolymer of 3 to 35% by mass. The MFR (190˚C, 2.16 kg) is preferably 0.3 g/10 min. to 30 g/10 min., more preferably 0.5 g/10 min. to 30 g/10 min., still more preferably 0.8 g/10 min. to 25 g/10 min..

The polyolefin-based resins are preferably polyethylene-based resins, polypropylene-based resins, and polybutene-based resins. Here, the polyethylene-based resin refers to a homopolymer of ethylene or a copolymer of ethylene and one or two or more other monomers. The polypropylene-based resin refers to a homopolymer of propylene or a copolymer of propylene and one or two or more other monomers.

Examples of the polyethylene-based resin include a polyethylene and an ethylene-$\alpha$-olefin copolymer.

Examples of the polyethylene include low density polyethylene (LDPE), linear low density polyethylene (LLDPE), and linear ultralow density polyethylene (referred to as "VLDPE" or "ULDPE").

The ethylene-$\alpha$-olefin copolymer is preferably a copolymer of ethylene and at least one selected from $\alpha$-olefins each having 3 to 20 carbons, and more preferably a copolymer of ethylene and $\alpha$-olefins each having 3 to 12 carbons. Examples of the $\alpha$-olefin include propylene, 1-butene, 1-pentene, 1-hexene, 1-octene, 4-methyl-1-pentene, 3-methyl-1-pentene, 1-decene, 1-dodecene, 1-tetradecene, 1-hexadecene, 1-octadecene, and 1-eicosane, and a combination of one or two or more thereof may be used. The percentage of the $\alpha$-olefin in all monomers constituting the copolymer (based on the monomers charged) is preferably 6 to 30% by mass. In addition, the ethylene-$\alpha$-olefin copolymer is preferably a soft copolymer, and preferably has a crystallinity of 30% or less as determined by an X-ray method.

As the ethylene-$\alpha$-olefin copolymer, a copolymer of ethylene and at least one comonomer selected from propylene comonomer, butene comonomer, hexene comonomer, and octene comonomer is generally readily available and can be suitably used.

The polyethylene-based resin can be produced by polymerization using a well-known catalyst such as a single site-based catalyst and a multisite-based catalyst, and is preferably produced by polymerization using a single site-based catalyst. The polyethylene-based resin preferably has a density of 0.860 to 0.920 g/cm$^3$, more preferably 0.870 to 0.915 g/cm$^3$, still more preferably 0.870 to 0.910 g/cm$^3$ from the viewpoint of cushioning properties. If the density is 0.920 g/cm$^3$ or less, the cushioning properties will tend to be good. If the density is more than 0.920 g/cm$^3$, the transparency may be worse. When a high density polyethylene-based resin is used, a low density polyethylene-based resin can also be added, for example, in a percentage of about 30% by mass to improve the transparency.

The polyethylene-based resin preferably has an MFR (190˚C, 2.16 kg) of 0.5 g/10 min. to 30 g/10 min., more preferably 0.8 g/10 min. to 30 g/10 min., still more preferably 1.0 g/10 min. to 25 g/10 min. from the viewpoint of the processability of the sealing resin sheet.

As the polyethylene-based resin, a polyethylene-based copolymer may also be used whose crystal/amorphous structure (morphology) is controlled in nano-order.

Examples of the polypropylene-based resin include polypropylene, propylene-α-olefin copolymers, and terpolymers of propylene, ethylene, and α-olefins.

The propylene-α-olefin copolymer refers to a copolymer composed of propylene and at least one selected from α-olefins. The propylene-α-olefin copolymer is preferably a copolymer composed of propylene and at least one selected from ethylene and α-olefins each having 4 to 20 carbons, and more preferably a copolymer composed of propylene and at least one selected from ethylene and α-olefins each having 4 to 8 carbons. Here, examples of the α-olefin having 4 to 20 carbons include propylene, 1-butene, 1-pentene, 1-hexene, 1-octene, 4-methyl-1-pentene, 3-methyl-1-pentene, 1-decene, 1-dodecene, 1-tetradecene, 1-hexadecene, 1-octadecene, and 1-eicosane, and a combination of one or two or more thereof may be used. A content of ethylene and/or an α-olefin in all monomers constituting the propylene-α-olefin copolymer (based on the monomers charged) is preferably 6 to 30% by mass. In addition, the propylene-α-olefin copolymer is preferably a soft copolymer, and preferably has a crystallinity of 30% or less as determined by an X-ray method.

As the propylene-α-olefin copolymer, a copolymer of propylene and at least one comonomer selected from ethylene comonomer, butene comonomer, hexene comonomer, and octene comonomer is generally readily available and can be suitably used.

The polypropylene-based resin can be produced by polymerization using a well-known catalyst such as a single site-based catalyst and a multisite-based catalyst, and is preferably produced by polymerization using a single site-based catalyst. The polypropylene-based resin preferably has a density of 0.860 to 0.920 $g/cm^3$, more preferably 0.870 to 0.915 $g/cm^3$, still more preferably 0.870 to 0.910 $g/cm^3$ from the viewpoint of cushioning properties. If the density is 0.920 $g/cm^3$ or less, the cushioning properties will tend to be good. If the density is more than 0.920 $g/cm^3$, the transparency may be worse.

The polypropylene-based resin preferably has an MFR (230˚C, 2.16 kgf) of 0.3 g/10 min. to 15.0 g/10 min., more preferably 0.5 g/10 min. to 12 g/10 min., still more preferably 0.8 g/10 min. to 10 g/10 min. from the viewpoint of the processability of the sealing resin sheet.

As the polypropylene-based resin, a polypropylene-based copolymer may also be used whose crystal/amorphous structure (morphology) is controlled in nano-order.

As the polypropylene-based resin, a copolymer of propylene and an α-olefin such as ethylene, butene, hexene, and octene, or a terpolymer of propylene, ethylene, and an α-olefin such as butene, hexene, and octene can be suitably used. Each of these copolymers may be in any form of a block copolymer, a random copolymer, and the like, and is preferably a random copolymer of propylene and ethylene, or a random copolymer of propylene, ethylene, and butene.

The polypropylene-based resins may be a resin produced by polymerization using a metallocene-based catalyst or the like as well as a resin produced by polymerization using a catalyst such as a Ziegler-Natta catalyst; for example, a syndiotactic polypropylene, an isotactic polypropylene, and the like may also be used. The percentage of propylene in all monomers constituting the polypropylene-based resin (based on the monomers charged) is preferably 60 to 80% by mass. In addition, in view of being excellent in heat shrinkability, the polypropylene-based resin is preferably a terpolymer in which the content of propylene in all monomers constituting the polypropylene-based resin (based on the monomers charged) is 60 to 80% by mass, the ethylene content (based on the monomers charged) is 10 to 30% by mass, and the butene content (based on the monomers charged) is 5 to 20% by mass.

As the polypropylene-based resin, a resin may also be used in which a rubber component is uniformly and finely dispersed in a high concentration of 50% by mass or less based on the total amount of the polypropylene-based resin.

If the adhesive resin layer contains the polypropylene-based resin, the characteristics (hardness, heat resistance, etc.) of the sealing resin sheet will tend to be improved.

The polybutene-based resin is preferably used in combination with the polypropylene-based resin for the purpose of adjusting the hardness or stiffness of the sealing resin sheet because it is excellent in compatibility with the polypropylene-based resin. As the polybutene-based resin, a high molecular weight polybuten-based e resin can be suitably used which is crystalline and a copolymer composed of butene and at least one selected from ethylene, propylene, and olefin-based compounds each having 5 to 8 carbons, and has a content of butene in all monomers constituting the polybutene-based resin of 70 mole % or more.

The polybutene-based resin preferably has an MFR (190˚C, 2.16 kg) of 0.1 g/10 min. to 10 g/10 min. It also preferably has a Vicat softening temperature of 40 to 100˚C. Here, the Vicat softening temperature is a value as measured according to JIS K7206-1982.

The content of the adhesive resin in the adhesive resin layer constituting the sealing resin sheet according to the present embodiment is preferably 10 to 100% by mass, more preferably 20 to 100% by mass, still more preferably 35 to 95% by mass. If the adhesive resin content is 10% by mass or more, the adhesion of the sealing resin sheet will tend to be good.

The content of the thermoplastic resin in the adhesive resin layer constituting the sealing resin sheet according to the present embodiment is preferably 0 to 90% by mass, more preferably 0 to 80% by mass, still more preferably 5 to 70% by mass.

The sealing resin sheet according to the present embodiment may have a single layer structure or a multilayer structure; however, it is provided at least with the adhesive resin layer on the side contacting the material to be sealed. The structures are described below.

[Single Layer Structure]

The sealing resin sheet according to the present embodiment may have a single layer structure consisting of only the resin layer comprising the adhesive resin. When the sealing resin sheet has a single layer structure, the single layer structure may consist of only the adhesive resin; however, it is preferably a layer consisting of a mixed resin of the adhesive resin and at least one thermoplastic resin selected from the group consisting of an ethylene-vinyl acetate copolymer, an ethylene-aliphatic unsaturated carboxylic acid copolymer, an ethylene-aliphatic unsaturated carboxylate ester copolymer, and a polyolefin-based resin in view of ensuring good transparency, flexibility, adhesion to a material to be attached, and handleability.

When the saponified ethylene-vinyl acetate copolymer is contained as the adhesive resin in the adhesive resin layer constituting the sealing resin sheet, the saponification degree and content thereof may be adjusted as needed, thereby enabling the adhesion to the material to be sealed to be controlled. In view of adhesion and optical characteristics, the content of the saponified ethylene-vinyl acetate copolymer in the resin layer is preferably 3 to 60% by mass, more preferably 3 to 55% by mass, still more preferably 5 to 50% by mass.

When the sealing resin sheet has a single layer structure consisting of only the adhesive resin layer, the resin layer preferably has a gel fraction of 1 to 65% by mass, more preferably 2 to 60% by mass, still more preferably 2 to 55% by mass. If the gel fraction of the resin layer is 1% by mass or more, the creep resistance will tend to be good, and if the gel fraction is 65% by mass or less, the property of filling-in clearance will tend to be good.

Means for adjusting the gel fraction to the above range include a method which involves, when cross-linking is performed by irradiation with ionizing radiation as described later, adjusting the irradiation dose, or a method which involves, when cross-linking is carried out using an organic peroxide, adjusting the concentration of the organic peroxide in the resin. For the cross-linking by ionizing radiation, the adjustment can be performed by irradiation strength (acceleration voltage) and irradiation density. The irradiation strength (acceleration voltage) indicates how deeply it allows electrons to reach in the thickness direction of the sheet, and the irradiation density indicates how many electrons per unit area irradiation are performed with. Methods for cross-linking using an organic peroxide include a method which involves adjusting the content of the organic peroxide and a method which involves using the organic peroxide in combination with a radical scavenger, trapping radicals produced by the decomposition of the organic peroxide. Examples of the radical scavenger include phenolic-based, phosphorous-based, sulfuric-based, and HALS-based scavengers. The difference in the cross-linking degree depending on the type of the resin or the cross-linking-promoting or - suppressing effect of a transferring agent or the like may also be utilized. The gel fraction can be measured according to a method as described in Examples below.

When the sealing resin sheet has a single layer structure consisting of only the adhesive resin layer, the resin layer may have a graded cross-linked structure. Here, the graded cross-linked structure means a structure for which the cross-linking degree (gel fraction) is changed (graded) along the thickness direction of the resin; examples thereof include a structure for which the cross-linking degree is decreased from the surface towards the inside, or a structure for which the cross-linking degree is increased from the surface towards the inside. Means for forming such structures include, for example, a method which involves, when cross-linking is performed by irradiation with ionizing radiation as described later, changing the irradiation dose along thickness direction, or a method which involves, when cross-linking is carried out using an organic peroxide, changing the concentration of the organic peroxide in the resin along thickness direction.

[Multilayer Structure]

The sealing resin sheet according to the present embodiment may have a multilayer structure of at least two layers comprising a surface layer and an internal layer laminated on the surface layer. Here, two layers forming both surfaces of the sealing resin sheet are referred to as "surface layers", and the other is referred to as "an internal layer".

When the sheet has a multilayer structure, the resin layer comprising the adhesive resin as described above is preferably formed as a layer contacting the material to be sealed (at least one of the surface layers). The surface layer may be a layer consisting of only the adhesive resin as described above; however, it is preferably a layer consisting of a mixed resin of the adhesive resin and at least one thermoplastic resin selected from the group consisting of an ethylene-vinyl acetate copolymer, an ethylene-aliphatic unsaturated carboxylic acid copolymer, an ethylene-aliphatic unsaturated carboxylate ester copolymer, and a polyolefin-based resin in view of ensuring good transparency, flexibility, adhesion to a material to be attached, and handleability.

The surface layer contacting the material to be sealed preferably has a thickness ratio of at least 5% or more based on the whole thickness of the sealing resin sheet. If the thickness ratio is 5% or more, the adhesion comparable to that for the single layer structure will tend to be provided.

The resin constituting the internal layer is not particularly limited and may be any other resin. For the purpose of imparting other functions, a resin material, a mixture, an additive, or the like may be selected for the internal layer. For example, a layer comprising a thermoplastic resin may be provided as the internal layer for the purpose of newly imparting cushioning properties.

Examples of the thermoplastic resins used as the internal layer include polyolefin-based resins, styrene-based resins, vinyl chloride-based resins, polyester-based resins, polyurethane-based resins, chlorine-containing ethylene polymer-based resins, and polyamide-based resins, and also include those having biodegradability and those from plant-derived raw materials-based. Among others, preferred are a hydrogenated block copolymer resin, a propylene-based copolymer resin, and an ethylene-based copolymer resin excellent in compatibility with a crystalline polypropylene-based resin and having good transparency; more preferred are a hydrogenated block copolymer resin and a propylene-based copolymer resin.

The hydrogenated block copolymer resin is preferably a block copolymer of a vinyl aromatic hydrocarbon and a conjugated diene. Examples of the vinyl aromatic hydrocarbon include styrene, o-methylstyrene, p-methylstyrene, p-tert-butylstyrene, 1,3-dimethylstyrene, $\alpha$-methylstyrene, vinylnaphthalene, vinylanthracene, 1,1-diphenylethylene, N,N-dimethyl-p-aminoethylstyrene, and N,N-diethyl-p-aminoethylstyrene; styrene is particularly preferable. These may be used alone or in a mixture of two or more thereof. The conjugated diene is a diolefin having a pair of conjugated double bonds; examples thereof include 1,3-butadiene, 2-methyl-1,3-butadiene (isoprene), 2,3-dimethyl-1,3-butadiene, 1,3-pentadiene, and 1,3-hexadiene. These may be used alone or in a mixture of two or more thereof.

The propylene-based copolymer resin is preferably a copolymer obtained propylene and ethylene or an $\alpha$-olefin having 4 to 20 carbon atoms. The resin preferably has a content of ethylene or the $\alpha$-olefin having 4 to 20 carbon atoms of 6 to 30% by mass. Examples of the $\alpha$-olefin having 4 to 20 carbon atoms include 1-butene, 1-pentene, 1-hexene, 1-octene, 4-methyl-1-pentene, 3-methyl-1-pentene, 1-decene, 1-dodecene, 1-tetradecene, 1-hexadecene, 1-octadecene, and 1-eicosane.

The propylene-based copolymer resin may be obtained by polymerization using a multisite-based catalyst, a single site-based catalyst, or any other catalyst. In addition, a propylene-based copolymer may be used whose crystal/amorphous structure (morphology) is controlled in nano-order.

The ethylene-based copolymer resin may be obtained by polymerization using a multisite-based catalyst, a single site-based catalyst, or any other catalyst. An ethylene-based copolymer may also be used whose crystal/amorphous structure (morphology) is controlled in nano-order.

When the polyethylene-based resin is used as a material for the internal layer, the polyethylene-based resin preferably has a density of 0.860 to 0.920 g/cm$^3$, more preferably 0.870 to 0.915 g/cm$^3$, still more preferably 0.870 to 0.910 g/cm$^3$ in view of achieving moderate cushioning properties. When a resin layer having a density of 0.920 g/cm$^3$ or more is formed as the layer not contacting the material to be sealed (the internal layer), the transparency will tend to be worse.

When the sealing resin sheet has a multilayer structure providing surface layers and an internal layer, at least one of the surface layers preferably has a gel fraction of 1 to 65% by mass, more preferably 2 to 60% by mass, still more preferably 2 to 55% by mass. If the gel fraction of the at least one of the surface layers is 1% by mass or more, the creep resistance will tend to be good, and if the gel fraction is 65% by mass or less, the property of filling-in clearance will tend to be good.

When the sealing resin sheet has a multilayer structure providing surface layers and an internal layer, the sealing resin sheet preferably has a moisture vapor transmission rate of 40 g/m$^2$·day or less, more preferably 37 g/m$^2$·day or less, still more preferably 35 g/m$^2$·day or less. If the moisture vapor transmission rate is 40 g/m$^2$·day or less, metal parts used in the power generation section and the peripheral wiring in a solar cell module will tend to be protected over a long period of time from moisture vapor gaining entry from the outside.

Means for adjusting the moisture vapor transmission rate of the sealing resin sheet to the above range include a method which involves adopting a resin with a low moisture vapor transmission rate as the resin used in the internal layer, or a method which involves increasing the thickness of the internal layer. Examples of the resin with a low moisture vapor transmission rate include polypropylene-based resins, nylon-based resins, high density polyethylenes, and cyclic polyolefins. The moisture vapor transmission rate can be measured according to a method as described in Examples below.

When the sealing resin sheet according to the present embodiment has a multilayer structure, at least one of the surface layers may be in a cross-linked state and at least one of the internal layers may be uncross-linked. Here, the resin whose surface layer is in a cross-linked state refers to a resin being in a state in which the gel fraction has reached 3% by mass or more as a result of the polymer constituting the resin being physically or chemically cross-linked by a well-known method. The cross-linking method may be a method which involves cross-linking the surface layer by containing a compound such as an organic peroxide in the resin of the surface layer, or a method which involves cross-linking the surface layer using ionizing radiation. If the surface layer gel fraction is 3% by mass or more, the surface layer resin will be a sufficiently cross-linked state, and the cross-linked state will tend to stabilize the layer without melting the resin and allowing the material to be sealed to flow even in a high temperature condition such as in summer. The at least one of the surface layers indicates at least one surface layer not desired to cause the flow of the material to be sealed among the two surface layers of both sides constituting the sealing resin sheet, and may be both surface layers constituting the sealing resin sheet when used in a sealing resin sheet for solar cells.

For a method involving pre-irradiating the sheet with ionizing radiation or the like before sealing, followed by lamination, if the surface layer has too high a cross-linking degree, the sheet may unable to seal steps on a crystalline-based silicon cell, wiring, and the like without producing any clearance. Thus, the surface layer preferably has a gel fraction of 3 to 90% by mass, more preferably 5 to 85% by mass, still more preferably 8 to 80% by mass.

When the steps on a crystalline-based silicon cell, wiring, and the like are sealed without producing any clearance, the sealing may be affected by the thickness of the surface layer depending on the cross-linked state. When the surface layer has a high cross-linking degree, the surface layer preferably has a thin thickness. On the other hand, the firmly stable holding of a crystalline-based silicon cell and the like requires a certain degree of thickness; thus, the surface layer preferably has a thickness of 10 to 150 $\mu$m, more preferably 15 to 140 $\mu$m, still more preferably 20 to 120 $\mu$m.

The reason for using an uncross-linked layer in at least one of the internal layers is that recyclability is provided; for example, when disposed, a solar cell using a crystalline-based silicon cell is made possible to be separated into glass, power generation portions such as a crystalline-based silicon cell and wiring section therefor, a backsheet, and the like as members constituting the solar cell. For example, for separate disposal, a used solar cell is made at higher temperature than the melting point of a resin constituting at least one of the internal layers to melt the layer, facilitating the peeling thereof from the other layer. The peeling method may be any method including making the layer into a higher temperature state followed by displacing and peeling it by adopting a shear force to be applied to the laminated part, or peeling it by inserting a wire or the like into the uncross-linked resin layer.

The uncross-linked layer preferably has a thickness of 15 $\mu$m or more, more preferably 20 $\mu$m or more, still more preferably 30 $\mu$m or more in view of peelability.

The sealing resin sheet will now be discussed in terms of processability. The resins constituting the adhesive resin layer and the other layer of the sealing resin sheet preferably have an MFR (190˚C, 2.16 kg) of 0.5 to 30 g/10 min., more preferably 0.8 to 30 g/10 min., still more preferably 1.0 to 25 g/10 min in view of ensuring good processability. When the sealing resin sheet has a multilayer structure of two or more layers, the resin constituting the internal layer (a middle layer or a lower layer) preferably has an MFR lower than that of the surface layer in view of the processability of the sealing resin sheet.

The sealing resin sheet according to the present embodiment may contain various additives, for example, a coupling agent, an anti-fogging agent, a plasticizer, an anti-oxidant, a surfactant, a colorant, an ultraviolet absorber, an antistatic agent, a crystal nucleating agent, a lubricant, an antiblocking agent, an inorganic filler, and a crosslink-controlling agent in such a range that the characteristics thereof are not compromised.

A coupling agent may be added to the sealing resin sheet for the purpose of ensuring stable adhesion. The addition amount and type of the coupling agent can be selected as needed depending on the desired degree of adhesion and the type of a material to be attached. The addition amount of the coupling agent is preferably 0.01 to 5% by mass, more preferably 0.03 to 4% by mass, still more preferably 0.05 to 3% by mass based on the total mass of the resin layer to which the coupling agent is to be added. The type of the coupling agent is preferably a substance imparting good adhesion to a solar cell and a glass to the resin layer; examples thereof include an organosilane compound, an organosilane peroxide, and an organotitanate compound. These coupling agents may be each added by a well-known addition method which involves pouring the agent on the resin in an extruder before mixing there, introducing a mixture thereof into an extruder hopper, adding it by masterbatching and mixing, or the like. However, when the coupling agent goes through an extruder, the function of the agent may be impaired by heat and pressure in the extruder; thus, it is necessary to properly adjust the addition amount thereof depending on the type of the coupling agent. The type of the coupling agent may be properly selected, considering the transparency and dispersion state of the sealing resin sheet, and corrosion on the extruder and extrusion stability. Preferred coupling agents include those having an unsaturated group or an epoxy group, such as γ-chloropropylmethoxysilane, vinyltrichlorosilane, vinyltriethoxysilane, vinyl-tris(β-methoxyethoxy)silane, γ-methacryloxypropyltrimethoxysilane, β-(3,4-ethoxycyclohexyl)ethyltrimethoxysilane, γ-glycidoxypropyltrimethoxysilane, vinyltriacetoxysilane, γ-mercaptopropyltrimethoxysilane, γ-aminopropyltriethoxysilane, N-β-(aminoethyl)-y-aminopropyltrimethoxysilaneglycidoxypropyltriethoxysilane.

An ultraviolet absorber, an antioxidant, a discoloration-preventing agent, and the like may be added to the sealing resin sheet. An ultraviolet absorber, an antioxidant, a discoloration-preventing agent, and the like are preferably added, particularly in the case when it is necessary to maintain transparency and adhesion over a long period of time. When these additives are each added to the resin, the addition amount thereof is preferably 10% by mass or less, more preferably 5% by mass or less based on the total amount of the resin to which the addition is to be performed.

Examples of the ultraviolet absorber include 2-hydroxy-4-n-octoxybenzophenone, 2-hydroxy-4-n-5-sulfobenzophenone, 2-hydroxy-4-methoxybenzophenone, 2,2'-dihydroxy-4,4'-dimethoxybenzophenone, 2-hydroxy-4-n-dodecyloxybenzophenone, 2,4-dihydroxybenzophenone, and 2,2'-dihydroxy-4-methoxybenzophenone. Examples of the anti-oxidant include phenolic-based, sulfuric-based, phosphorous-based, amine-based, hindered phenol-based, hindered amine-based and hydrazine-based antioxidants.

The ultraviolet absorber, antioxidant, discoloration-preventing agent, and the like may be added not only to the adhesive resin layer but also to the other layer, and is each preferably added 0 to 10% by mass, more preferably 0 to 5% by mass based on the resin constituting each layer. When these agents are added to the ethylene-based resin, the adhesion thereof can also be further imparted thereto by masterbatching and mixing a resin having a silanol group.

The addition method is not particularly limited; examples thereof include a method involving adding the agent in liquid form to the melted resin, a method involving adding the agent by kneading it directly into the resin layer of interest, a method involving coating the agent after sheeting, and the like.

A scavenger for water and/or gas may be carried by the sealing resin sheet according to the present embodiment. The scavenger for water and/or gas (hereinafter simply referred to as a scavenger) will be described. The scavenger is a substance having the function of physically and chemically trapping and fixing water and gas. The gas refers to a substance which is low molecular weight or decomposed matter contained in the resin or generated during the softening step and has volatility at ordinary temperature under constant pressure.

The material as the scavenger is not particularly limited provided that it has the function of trapping water and gas. Examples thereof include porous inorganic materials such as zeolite, alumina, molecular sieves, and silicon oxide, metal alloys, metal oxides, and metal oxide salts (salts of metals with oxides). Particularly, metal alloys, metal oxides, and metal oxide salts are preferable because they can chemically trap water and gas and do not again release the once-trapped component.

Examples of the metal alloy which is preferably used are alloy systems of zirconium or strontium with aluminum or titanium. These metal alloy systems generally deliver the trapping function by external heating or heating through the passage of electric current. Examples of the metal oxide and metal oxide salt which is preferably used are alkali earth metal oxides and metal sulfates. Examples of the alkali earth metal oxide include calcium oxide (CaO), barium oxide (BaO), and magnesium oxide (MgO). Examples of the metal sulfate include lithium sulfate ($Li_2SO_4$), sodium sulfate ($Na_2SO_4$), calcium sulfate ($CaSO_4$), magnesium sulfate ($MgSO_4$), cobalt sulfate ($CoSO_4$), gallium sulfate ($Ga_2(SO_4)_3$), titanium sulfate ($Ti(SO_4)_2$), and nickel sulfate ($NiSO_4$).

A method for carrying the scavenger will now be described. Examples thereof include a method involving applying a molded product comprising a layer of the scavenger to a certain sheet constituting the resin layer, a method involving causing the scavenger to be contained in a resin layer constituting the sealing resin sheet or the other certain layer, and a method involving applying the scavenger to at least one principal surface of a certain sheet. "One principal surface" means the front or back side of the sealing resin sheet. The scavenger may be applied or coated on the sheet (the resin layer), followed by further forming a resin layer by extrusion lamination or the like to make a structure comprising the scavenger layer as the internal layer.

A method for applying the molded product comprising the scavenger will be described. Examples thereof include a method which involves coating the scavenger on a certain stainless sheet, which is then baked at about 400 to 1,000°C for 1 to 5 hours to form a scavenger layer having a thickness of about 50 to 500 μm, and subsequently putting an adhesive on the scavenger layer, followed by transferring the scavenger to a certain sheet constituting the resin layer. Examples thereof also include a method which involves transferring the resulting scavenger layer directly to the sealing resin sheet by heat lamination.

A method for causing the scavenger to be contained in the resin layer constituting the sealing resin sheet will be described. Examples thereof include a method which involves mixing the resin and the scavenger in an extruder, followed by forming a film, and a method which involves preparing a master batch in which the resin is caused to contain the scavenger in a high concentration in advance and mixing the batch in film-forming.

When the scavenger is caused to be contained in the resin layer of the sealing resin sheet, the scavenger preferably has a particle diameter of 50 μm or less, more preferably 30 μm or less, still more preferably 20 μm or less. The scavenger particle diameter of 50 μm or less is preferable because it can prevent the occurrence of rupture at film-forming and the deposition of the particles as an extraneous material on the surface.

The content of the scavenger is set depending on the type of the scavenger and the thickness of the sealing resin sheet. Specifically, the scavenger/the resin component is preferably 1/99 to 70/30, more preferably 2/95 to 40/60, still more preferably 3/97 to 50/50 based on 100% by mass of the total of the scavenger and the resin component. If the scavenger content is 1% by mass or more, the trapping capability thereof will tend to be sufficiently delivered, and if the content is 70% by mass or less, stability during film-forming will tend to increase.

As a method for coating the scavenger, heretofore known methods may be applied. For example, a spray coating method, a bar coat method, and a gravure printing method are preferable, but are not limited thereto. When the scavenger is coated, the scavenger preferably has a particle diameter of 50 $\mu$m or less, more preferably 30 $\mu$m or less, still more preferably 20 $\mu$m or less. If the scavenger particle diameter is 50 $\mu$m or less, the occurrence of clogging during coating will tend to be avoided.

The solvent for coating is not particularly limited; however, it is preferably an aprotic-based solvent having a low water content. A binder component such as an acrylic resin and an urethane resin may be blended in the solution. A dispersing auxiliary agent may also be further added.

[Cross-linking Method]

When used as a sealing resin sheet for solar cells, the sealing resin sheet according to the present embodiment is required to have heat resistance under high temperatures; thus, the resin layer comprising the adhesive resin and other layers are preferably cross-linked.

Cross-linking methods include heretofore known methods such as a method using irradiation with ionizing radiation and a method using an organic peroxide (e.g. a peroxide).

Examples of the method for cross-linking by irradiation with ionizing radiation include a method which involves cross-linking by irradiating the sealing resin sheet with ionizing radiation such as $\alpha$, $\beta$, $\gamma$, neutron, and electron rays. The acceleration voltage for ionizing radiation such as electron rays may be selected depending on the thickness of the sealing resin sheet; for example, for the thickness of 500 $\mu$m, the cross-linking of the resin constituting the whole layer requires an acceleration voltage of 300 kV or more.

The acceleration voltage for ionizing radiation such as electron rays can be properly controlled according to the resin layer to be subjected to cross-linking treatment. The irradiation dose of ionizing radiation varies depending on the resin used; however, in general, when the irradiation dose of ionizing radiation is less than 3 kGy, a uniform cross-linked sealing resin sheet can not be obtained. On the other hand, if the irradiation dose of ionizing radiation is more than 500 kGy, the gel fraction of the sealing resin sheet is too large, and the property of filling-in irregularity steps and clearance may not be ensured when the sheet is used in solar cells.

The acceleration voltage for and irradiation dose of ionizing radiation are preferably regulated as needed to obtain a desired gel fraction. The degree of cross-linking can be evaluated by measuring the gel fraction.

To achieve the above range of the gel fraction, the difference in the degree of cross-linking depending on the resin type or the cross-linking-promoting or - inhibiting effect of a transferring agent may be utilized in addition to the irradiation dose of ionizing radiation.

For example, for the sealing resin sheet having a multilayer structure, when a polar group-containing resin such as a copolymer of ethylene monomer and vinyl acetate, an aliphatic unsaturated carboxylic acid, or an aliphatic unsaturated carboxylate ester and a saponified product thereof is used as the surface layer, and linear low density polyethylene (LLDPE) resin or linear ultralow density polyethylene (that called "VLDPE" or "ULDPE") resin is used as the internal layer, even if the acceleration voltage is sufficient to allow the passing through all of the layers, the gel fraction of the surface layer can increase and the gel fraction of the internal layer can decrease.

In addition, the adjustment of the acceleration voltage enables the linear low density polyethylene (LLDPE) resin layer or linear ultralow density polyethylene (that called "VLDPE" or "ULDPE") resin layer of the internal layer to be constructed as an uncross-linked layer and the surface layer to be subjected to cross-linking processing by electron beam irradiation. When a polyethylene-based resin is used as the internal layer, an uncross-linked layer can be constructed because the polypropylene-based resin cannot be cross-linked with electron rays or the like.

For the cross-linking using an organic peroxide, thermal cross-linking is carried out by blending or impregnating the organic peroxide as a cross-linking agent in the resin. In this case, the organic peroxide preferably has an half-life of one hour or less at 100 to 130˚C.

Examples of the organic peroxide include 1,1-bis(t-butylperoxy)-3,3,5-trimethylcyclohexane, 1,1-bis(t-butylperoxy)cyclohexane, n-butyl-4,4-bis(t-butylperoxy)valerate, and 2,2-bis(t-butylperoxy)butane which provide good compatibility and have the above half-life.

For sealing resin sheets using these organic peroxides, the cross-linking time can be made relatively short, and the cure step can be shortened by about half compared to when a conventionally widely used organic peroxide is employed having a half-life of one hour or more at 100 to 130˚C.

The content of the organic peroxide is preferably 0 to 10% by mass, more preferably 0 to 5% by mass based on the resin layer to be cross-linked.

The sealing resin sheet blended with the organic peroxide has the advantage that an increased gel fraction does not impair the property of filling-in clearance because the sheet is softened during lamination and the decomposition and cross-linking of the organic peroxide are promoted after the filling-in of clearance.

As described above, "cross-linking" methods include a method involving performing irradiation with ionizing radiation and a method involving utilizing an organic peroxide; however, the method involving cross-linking by irradiation with ionizing radiation is particularly preferable. That is, this method is excellent in that it can prevent the remaining of unreacted elements in the resin such as an organic acid and a peroxide due to the elimination of side chain moieties of ethylene-vinyl acetate copolymers, ethylene-aliphatic unsaturated carboxylic acid copolymers, ethylene-aliphatic unsaturated carboxylate ester copolymers, and saponified products thereof, thereby preventing adverse effects of the unreacted elements on solar cells and electric conductive functional layers or wiring.

The cross-linking method using the organic peroxide less easily speeds up the production of a solar cell module because the lamination step requires the cure time for decomposing the organic peroxide and promoting the cross-linking of the sealing resin sheet. However, the cross-linking method using irradiation with ionizing radiation is excellent also in that it requires no cure time and can improve the productivity of a solar cell module.

[Method for Producing Sealing Resin Sheet]

The method for producing the sealing resin sheet according to the present embodiment is not particularly limited; however, examples thereof include the following method. A resin is first melted in an extruder; a melted resin is extruded from a die; and a raw sheet is obtained by quenching and solidification. A T-die, a ring die, or the like is used as the extruder. When the sealing resin sheet has a multilayer structure, a ring die is preferable.

The surface of the raw sheet may be subjected to embossing treatment depending on the form of the finally intended sealing resin sheet. For example, the embossing treatment can be applied by passing the raw sheet between two heated embossing rolls when both sides are subjected to embossing treatment and between two embossing rolls only one of which is heated when one side is subjected to embossing treatment. When the sealing resin sheet is a multilayer structure, a multilayer T-die method and a multilayer circular die method are preferable; the multilayer structure may be formed by other well-known lamination methods.

The sealing resin sheet according to the present embodiment can be prepared using a well-known method; however, the film formation using a ring die is preferable because it exerts an excellent effect. The ring die as employed herein may use a commercially available well-known ring die. The film formation using a ring die involves, for example, forming a sealing resin sheet having a substantially constant thickness in tube form by melting a resin, extruding the melted resin through a ring die, hardening it by cooling, sealing the cylindrical resin tube using a pair of nip rolls, and forming a film by letting air go into the cylindrical resin tube. When the extruder has a sufficiently high capacity, the diameter of the resin tube allows a sufficient amount of the melted resin to be extruded through the ring die, and making the resin tube diameter about the same as, or larger than, that of the ring die results in the preferential stretching of a thicker portion of the tube until the resin is hardened by cooling, thereby dramatically improving the film thickness accuracy of a sealing resin sheet to provide a sealing resin sheet having a uniform thickness. To improve the weather resistance of the resin itself, additives such as a light-resisting agent and an ultraviolet absorber may be mixed by masterbatching the additives to charge the batch with the resin in a hopper of the extruder or injecting the additives in solution form through an addition hole created in the screw section of the extruder.

In addition, the use of such a ring die can dramatically reduce the cost of equipment compared to a film-forming method using a T-die or a calendar film-forming method in view of equipment and enables the preparation of a uniform sealing resin sheet at a high speed using inexpensive equipment, providing a high cost merit. Such a film-forming method using a ring die can use various types of resins or the same type of resins having different densities or different MFRs and thus can prepare various sealing resin sheets using the same equipment. Furthermore, the method enables efficient production because it minimizes loss during the formation of the sealing resin sheet and slit loss such as an edge face portion of the sheet, and is an epoch-making method because a portion such as slit loss can be recycled by repelletization to achieve the cost reduction of the sealing resin sheet.

When additives are added to the sealing resin sheet thus prepared, the sealing resin sheet formed by extrusion through the ring die has about the same thermal history in any location of the sealing resin sheet, and, as a result, can deliver approximately uniform functions derived from the additives. Even when the effect of an additive varies depending on the thermal history as in the case of an organic peroxide, the sealing resin sheet prepared using a ring die has little residence area of the resin and thermal history under about the same conditions; thus, approximately uniform physical properties can be achieved in any location of the sealing resin sheet. In addition, when the ring die is a multilayer circular die, a sealing resin sheet having a multilayer structure can be prepared and thus functional partition such as into improved adhesion of a surface layer for the surface layer and improved cushioning properties for an internal layer is possible, enabling the preparation of a higher-performance sealing resin sheet. Further, little deformation when the resin is melted enables the reduction of flow orientation. The melted resin is hardened slowly in cooling during film formation to provide a sealing resin sheet having a low shrinkage rate.

A sheet-like sealing resin sheet can be obtained by cutting a part of the resin tube thus prepared in film form. Other functions can be imparted to the sealing resin sheet using well-known methods such as embossing and printing working depending on the method for utilization of the sealing resin sheet.

In the method for preparing a resin tube by extruding a melted resin through a ring die followed by hardening under cooling, the resin may be upwardly spewed out or downwardly spewed out through the ring die provided that the resin tube can be prepared in film form. The cooling method may be air cooling, water cooling, or a combination of air cooling and water cooling, if the resin can be cooled and solidified.

In addition, as aftertreatment, for example, heat setting for dimensional stabilization, corona treatment, plasma treatment, or lamination with a different type of a sealing resin sheet or the like may be carried out.

It is selected whether the cross-linking treatment of the resin layer constituting the sealing resin sheet, i.e. irradiation treatment with ionizing radiation or heat treatment by use of an organic peroxide or the like, is performed as a preceding process for embossing treatment or as a post-process therefor, depending on each case.

[Characteristic of Sealing Resin Sheet]

The optical characteristic of the sealing resin sheet will now be described. The haze value is used as a measure of optical characteristics. The haze value is measured using a predetermined optical measurement machine. The sheet having a haze value of 10.0% or less is preferable because it enables the recognition of a material in the material sealed with the sealing resin sheet from the appearance of the sealed material, and provides a practically sufficient power generation efficiency when the power generation element of a solar cell is sealed with the sheet. From such a viewpoint, the haze value is preferably 9.5% or less, more preferably 9.0% or less. Here, the haze value can be measured according to ASTM D-1003.

The sealing resin sheet according to the present embodiment preferably has a total light transmittance of 85% or more, more preferably 87% or more, still more preferably 88% or more to ensure a practically sufficient power generation efficiency when used as a sealer for the power generation element of a solar cell. Here, the total light transmittance can be measured according to ASTM D-1003.

The sealing resin sheet according to the present embodiment preferably has a thickness of 50 to 1,500 $\mu$m, more preferably 100 to 1,000 $\mu$m, still more preferably 150 to 800 $\mu$m. If the thickness is less than 50 $\mu$m, cushioning properties may be poor structurally and problems with durability and strength will tend to arise from the viewpoint of workability. On the other hand, if the thickness is more than 1,500 $\mu$m, a problem that it leads to reduced productivity and decreased adhesion will tend to arise.

[Intended Use of Sealing Resin Sheet]

The sealing resin sheet according to the present embodiment is particularly useful as a sealer for protecting members such as elements constituting a solar cell. That is, it is excellent in transparency and creep resistance, has good adhesion to a material to be sealed, and is controllable in adhesion depending on the intended use thereof. It also stably delivers strong adhesion to a glass plate or a resin plate such as acrylic resin plate and polycarbonate resin plate constituting a solar cell. The sealing resin sheet according to the present embodiment can be used to positively seal various members with irregularities such as a glass itself, various wiring and a power generation element for a solar cell without producing any clearance.

The sealing resin sheet according to the present embodiment can also be used for LED sealing, an interlayer of a laminated glass and a crime prevention glass and the like, adhesion between a plastic and a glass, between plastics, and between glasses, and the like as well as can be used as a sealing sheet for solar cells.

Here, when the sealing resin sheet is used as an interlayer of a laminated glass, for example, the sealing resin sheet can be held between two glass plates and/or resin plates to provide a composite material.

Examples

The present invention is described below with reference to Examples and Comparative Examples. Evaluations and treatments for objects to be measured are first described below.

<Gel Fraction>

For the all layer gel fraction, the sealing resin sheet was extracted in boiling p-xylene for 12 hours to calculate the percentage of the insoluble part from the following equation. The gel fraction was evaluated as a measure of the cross-linking degree of the sealing resin sheet.

$$\text{Gel fraction (\% by mass)} = \text{(Mass of Sample after Extraction/Mass of Sample before Extraction)} \times 100$$

For the surface layer gel fraction, a sheet of the same resin and the same thickness as those of the surface layer was prepared; ionizing radiation treatment was applied to the sheet; and the gel fraction thereof was calculated by the above method.

<Irradiation with Ionizing Radiation>

Electron ray treatment was applied to the sealing resin sheet at a predetermined acceleration voltage and irradiation density using EPS-300 or EPS-800 electron ray irradiation apparatus (from Nisshin High Voltage Corporation).

<Density ($\rho$)>

The density was measured according to JIS-K-7112.

<MFR>

MFR was measured according to JIS-K-7210. It is to be noted that the MFR shown in the tables that follow is expressed in g/10 min.

<Melting Point (mp)>

Using "Model MDSC2920" from TA Instruments as a differential scanning calorimeter, about 8 to 12 mg of a resin was temperature increased at a rate of 10°C/minute from 0°C to 200°C, held in a molten state at 200°C for 5 minutes followed by quenching to -50°C, and then temperature increased to at 10°C/minute from 0°C to 200°C, during which the resulting endothermic peak associated with melting was defined as the melting point.

<Haze and Total light transmittance>

These were measured according to ASTM D-1003. A glass plate for solar cells (white plate glass from AGC, 5 cm × 10 cm: 3 mm thick)/a sealing resin sheet/the glass plate for solar cells piled up in that order and vacuum laminated under conditions of 150°C and 15 minutes using Model LM50 (from NPC) as a vacuum lamination apparatus was used as a sample for evaluation.

<Moisture Vapor Transmission Rate>

This rate was measured according to JIS-K7129. A 150 $\mu$m film as a sample for evaluation was prepared using the same resin as that of the core layer of the sealing resin sheet and evaluated. However, in Example 23, a 150 $\mu$m film as a sample for evaluation was prepared using the same resin as that of the base layer of the sealing resin sheet and evaluated.

<Evaluation of Filling-Up Power Generation Portion Clearance>

A glass plate for solar cells (white plate glass from AGC, 5 cm × 10 cm: 3 mm thick)/a sealing resin sheet/a power generation portion (single-crystal silicon cell (250 $\mu$m thick))/the sealing resin sheet/the glass plate for solar cells were piled up in that order and vacuum laminated under conditions of 150°C and 15 minutes using Model LM50 (from NPC) as a vacuum lamination apparatus, and the condition of contact of the single-crystal silicon cell of the power generation portion with the sealing resin sheets was visually confirmed.

◎: Portions of contact of the single-crystal silicon cell with the sealing resin sheets are totally good. (no clearance)
○: Portions of contact of the single-crystal silicon cell with the sealing resin sheets are good. (no clearance)
×: Clearance occurred in portions of contact of the single-crystal silicon cell with the sealing resin sheets.

<Evaluation of Creep Resistance>

A glass plate for solar cells (white plate glass from AGC, 5 cm × 10 cm: 3 mm thick)/a sealing resin sheet/a power generation portion (single-crystal silicon cell (250 $\mu$m thick))/the sealing resin sheet/the glass plate for solar cells were piled up in that order and vacuum laminated using Model LM50 (from NPC) as a vacuum lamination apparatus, and one glass plate of the laminated solar cell was fixed on the wall of a thermostat set at 85°C, allowed to stand for 24 hours, and measured for creep between this plate and the other glass plate.

◎: No creep of the glass plates.
○: Almost no creep of the glass plates.
✕: 3 mm-or-more creep of the glass plates.

<Evaluation of Recyclability>

A glass plate for solar cells (white plate glass from AGC, 5 cm × 10 cm: 3 mm thick)/a sealing resin sheet/a power generation portion (single-crystal silicon cell (250 μm thick))/the sealing resin sheet/the glass plate for solar cells were piled up in that order and vacuum laminated under conditions of 150˚C and 15 minutes using Model LM50 (from NPC) as a vacuum lamination apparatus, and one glass plate of the laminated solar cell was fixed on the wall of a thermostat, allowed to stand for 24 hours, and measured for creep between this plate and the other glass plate.
The setting temperature of the thermostat was set to a temperature 30˚C higher than the highest melting point of the resins used in the sealing resin sheet.

◎: 5 mm-or-more creep of the glass plates.
○: 3 mm-or-more creep of the glass plates.
✕: Almost no creep of the glass plates.

<Temperature Humidity Cycle>

A solar cell module was prepared by piling up a glass plate for solar cells (white plate glass from AGC, 3 mm thick)/a sealing resin sheet/a power generation portion (single-crystal silicon cell (250 μm thick))/the sealing resin sheet/a backsheet for solar cells (from Toyo Aluminium K.K.) in that order and vacuum laminating this at 150˚C using Model LM50 (from NPC) as a vacuum lamination apparatus, and used as a sample for evaluation.
As the temperature humidity test cycle, the sample was held under conditions of -20˚C/2 hours and 85˚C/85% RH/2 hours, and the cycle was repeated 50 times.
A change in the appearance of the solar cell module after the above test was observed and evaluated on the following 3 scales.
Appearance

◎: No change in the appearance (Good)
○: Almost no change in the appearance (Good)
✕: A change in the appearance (Defective appearance due to partial peeling off and air voids)

<Evaluation of Storage Stability>

A sealing resin sheet to be evaluated was stored in a thermostatic chamber set at 40˚C and 50% RH for 4 months, and a change in the adhesion of the sealing resin sheet before and after storage was observed.
A glass plate for solar cells (white plate glass from AGC, 5 cm × 10 cm: 3 mm thick)/a sealing resin sheet/a backsheet for solar cells (from Toyo Aluminium K.K.) piled up in that order and vacuum laminated at 150˚C using Model LM50 (from NPC) as a vacuum lamination apparatus was used as a sample for evaluation.
After lamination, the peel strength between the sealing resin sheet and the glass was evaluated on the following 3 scales.
Peeling

◎: Less-than 20% change in the peel strength before and after storage (Good)
○: Less-than 30% change in the peel strength before and after storage (Good)
✕: 30%-or-more change in the peel strength before and after storage (Poor)

<Peel Strength between Sealing resin sheet and Glass>

A glass plate for solar cells (white plate glass from AGC, 5 cm × 10 cm: 3 mm thick)/a sealing resin sheet/the glass plate for solar cells piled up in that order and vacuum laminated at 150˚C using Model LM50 (from NPC) as a vacuum lamination apparatus was used as a sample. After lamination, the peel strength was evaluated by peeling the two glass plates for solar cells with hands.

○: Not peeled because of firm adhesion. (Good)
✕: Peeled with hands. (Poor)

<Adhesion Strength to Glass>

A glass plate for solar cells (white plate glass from AGC, 3 mm thick)/a sealing resin sheet/a backsheet for solar cells (from Toyo Aluminium K.K.) piled up in that order and vacuum laminated at 150°C using Model LM50 (from NPC) as a vacuum lamination apparatus was used as a sample for evaluation. The sample was cut vent 10mm wide on the backsheet side, partially peeled from the glass, and the strip sample was pulled at a rate of 50 mm/min. in the direction of 180° to measure the strength at that time.

<High Humidity Resistance Test>

A sample was prepared in the same way as in the test of adhesion strength to glass and stored under conditions of 23°C and 90% for one month. Subsequently, as described in the test of adhesion strength to glass, a strip sample was pulled at a rate of 50 mm/min. in the direction of 180° to measure the strength at that time.

Methods for preparing sealing resin sheets of Examples 1 to 23 and Comparative Examples 1 to 3 are described below. In each of Examples 1 to 22 and Comparative Examples 1 to 3, a certain core layer was held from the upper and lower sides thereof using a base layer and a surface layer to prepare a sealing resin sheet of a laminate configuration as shown in the following Tables 1 to 7. In Example 23, a certain base layer was put between two surface layers to prepare a sealing resin sheet of a laminate configuration. In Tables, the column of layer constitution is described, focusing attention on the types and number of raw material resins. The layer constitution is a "single layer" when the same raw material resin is used in the surface layer, the base layer, and the core layer. In addition, for example, 2 types 3 layers described in the column of Example 3 means that two surface layers are formed in the form of putting a core layer therebetween.

<Examples 1 to 23>

Resins as shown in Tables 1 to 6 were used. Certain resins were melted using three extruders (a surface layer extruder, a base layer extruder, and a core layer extruder); the resins were melt-extruded in the form of a tube through a ring die connected to the extruders; and the tube formed by the melt extrusion was quenched using a water cooling ring to provide sealing resin sheets shown in each of Examples 1 to 23. In introducing an organic peroxide and a silane coupling agent, these additives were each pre-kneaded at a concentration of about 5% in the resin to be introduced and thereby masterbatched, and this materbatch was used by dilution so as to provide a desired blending amount. In Tables, the thickness ratio indicates a ratio of the thickness of each layer based on 100 of the thickness of the whole sealing resin sheet.

The sealing resin sheets of Examples 1 to 21 were subjected to electron ray cross-linking treatment according to the "irradiation conditions" shown in Tables 1 to 6 below. An organic peroxide was used as a cross-linking agent in each of the sealing resin sheets of Examples 22 and 23. Each of the sealing resin sheets was evaluated for gel fraction, optical characteristics, and moisture vapor transmission rate. Using a glass for solar cells as a power generation surface member, a solar cell module was prepared to perform evaluation of filling-up solar cell power generation portion clearance and creep resistance evaluation. The results are shown in Tables 1 to 6. In addition, Solar cell modules were prepared using the sealing resin sheets of Examples 8, 13, 20, and 21 to carry out recyclability evaluation. The results are shown in Table 8.

<Comparative Examples 1 to 3>

Using resin materials as shown in Table 7, sealing resin sheets were prepared according to each condition as described in Examples. The sealing resin sheets were subjected to electron ray cross-linking treatment according to the "irradiation conditions" shown in Table 7.
Each of the sealing resin sheets was evaluated for gel fraction and optical characteristics.
Using a glass for solar cells as a power generation surface member, a solar cell module was prepared to perform evaluation of filling-up solar cell power generation portion clearance, creep resistance evaluation and recyclability evaluation. The results are shown in Table 7.
[Table 1]

| Layer constitution | | | | Ex. 1 | Ex. 2 | Ex. 3 | Ex. 4 |
|---|---|---|---|---|---|---|---|
| | | | | Single layer | Single layer | 2 Types 3 layers | 2 Types 3 layers |
| Surface layer | Resin | | | Ethylene-vinyl acetate copolymer | Ethylene-vinyl acetate copolymer | Ethylene-vinyl acetate copolymer | Ethylene-acrylic acid copolymer |
| | | Physical properties | | VA=27 wt%, MFR=13, mp=72°C | VA=28 wt%, MFR=5.7, mp=72°C | VA=28 wt%, MFR=5.7, mp=72°C | $\rho$=0.932 g/cm³, MFR=5.5, mp=99°C |
| | | Ratio | | 90 wt% | 55 wt% | 100 wt% | 100 wt% |
| | Resin | | | Linear ultra-low density polyethylene | Linear ultra-low density polyethylene | - | - |
| | | Physical properties | | $\rho$=0.863 g/cm³, MFR=0.5, mp=47°C | $\rho$=0.863 g/cm³, MFR=0.5, mp=47°C | - | - |
| | | Ratio | | 10 wt% | 45 wt% | - | - |
| | Thickness ratio | | | 10 | 10 | 10 | 10 |
| Base layer | Resin | | | Ethylene-vinyl acetate copolymer | Ethylene-vinyl acetate copolymer | Ethylene-vinyl acetate copolymer | Ethylene-acrylic acid copolymer |
| | | Physical properties | | VA=27 wt%, MFR=23, mp=72°C | VA=28 wt%, MFR=5.7, mp=72°C | VA=28 wt%, MFR=5.7, mp=72°C | $\rho$=0.932 g/cm³, MFR=5.5, mp=99°C |
| | | Ratio | | 90 wt% | 55 wt% | 100 wt% | 100 wt% |
| | Resin | | | Linear ultra-low density polyethylene | Linear ultra-low density polyethylene | - | - |
| | | Physical properties | | $\rho$=0.863 g/cm³, MFR=0.5, mp=47°C | $\rho$=0.863 g/cm³, MFR=0.5, mp=47°C | - | - |
| | | Ratio | | 10 wt% | 45 wt% | - | - |
| | Thickness ratio | | | 80 | 80 | 80 | 80 |
| Core layer | Resin | | | Ethylene-vinyl acetate copolymer | Ethylene-vinyl acetate copolymer | Linear ultra-low density polyethylene | Linear ultra-low density polyethylene |
| | | Physical properties | | VA=27 wt%, MFR=23, mp=72°C | VA=28 wt%, MFR=5.7, mp=72°C | $\rho$=0.863 g/cm³, MFR=0.5, mp=47°C | $\rho$=0.863 g/cm³, MFR=0.5, mp=47°C |
| | | Ratio | | 90 wt% | 55 wt% | 100 wt% | 100 wt% |
| | Resin | | | Linear ultra-low density polyethylene | Linear ultra-low density polyethylene | - | - |
| | | Physical properties | | $\rho$=0.863 g/cm³, MFR=0.5, mp=47°C | $\rho$=0.863 g/cm³, MFR=0.5, mp=47°C | - | - |
| | | Ratio | | 10 wt% | 45 wt% | - | - |
| | Thickness ratio | | | 10 | 10 | 10 | 10 |
| Sheet thickness | | | | 450 μm | 450 μm | 450 μm | 450 μm |
| Cross-linking method | | | | | | | |
| Ionizing radiation irradiation conditions | | | | | | | |
| | Apparatus | | | EPS-800 | EPS-800 | EPS-800 | EPS-800 |
| | Acceleration voltage | | | 500 kV | 500 kV | 500 kV | 500 kV |
| | Irradiation density | | | 30 kGy | 30 kGy | 30 kGy | 30 kGy |
| Organic peroxide | | | | - | - | - | - |
| | Blending ratio to sealing sheet | | | - | - | - | - |
| Gel fraction | All layer gel fraction (%) | | | 30 | 20 | 31 | 21 |
| | Surface layer gel fraction (%) | | | 33 | 22 | 38 | 24 |
| Optical characteristics | Haze (%) | | | 8.8 | 9.7 | 7.3 | 8.1 |
| | Total light transmittance (%) | | | 87 | 85 | 89 | 88 |
| Moisture vapor transmission rate (g/m²/24 hr) | | | | 39 | 10 | 21 | 21 |
| Module evaluation | Filling-up power generation portion clearance | | | ◎ | ◎ | ◎ | ◎ |
| | Creep resistance | | | ◎ | ◎ | ◎ | ◎ |

[Table 2]

| | Ex. 5 | Ex. 6 | Ex. 7 | Ex. 8 |
|---|---|---|---|---|
| Layer constitution | 2 Types 3 layers | 2 Types 3 layers | 2 Types 3 layers | 2 Types 3 layers |

(continued)

| | | | | Ex. 5 | Ex. 6 | Ex. 7 | Ex. 8 |
|---|---|---|---|---|---|---|---|
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28wt%, MFR=5.7, mp=72˚C | VA=28 wt%, MFR=5.7, mp=72˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 10 | 10 | 10 | 10 |
| | Base layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28wt%, MFR=5.7, mp-72˚C | VA=28 wt%, MFR--5.7, mp=72˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 70 | 60 | 70 | 80 |
| | Cora layer | Resin | | Low density polyethylene | Ethylene-propylene-butene copolymer | Ethylene-propylene copolymer | Ethylene-propylene-butene copolymer |
| | | | Physical properties | $\rho$=0.921 g/cm$^3$, MFR=0.4, mp=120˚C | $\rho$=0.900 g/cm$^3$, MFR=5.5, mp=133˚C | $\rho$=0.876 g/cm$^2$, MFR=2.0 | $\rho$=0.900 g/cm$^3$, MFR=5.5, mp=133˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 20 | 30 | 20 | 10 |
| Sheet thickness | | | | 450 μm | 450 μm | 450 μm | 450 μm |
| Cross-linking method | | | | | | | |

(continued)

| | | | Ex. 5 | Ex. 6 | Ex. 7 | Ex. 8 |
|---|---|---|---|---|---|---|
| | Ionizing radiation irradiation conditions | | | | | |
| | | Apparatus | EPS-800 | EPS-800 | EPS-800 | EPS-800 |
| | | Acceleration voltage Irradiation density | 500 kV | 500 kV | 500 kV | 500 kV |
| | | | 30 kGy | 20 kGy | 30 kGy | 30 kGy |
| | Organic peroxide | | - | - | - | - |
| | | Blending ratio to sealing sheet | - | - | - | - |
| Gel fraction | | All layer gel fraction (%) | 35 | 23 | 27 | 25 |
| | | Surface layer gel fraction (%) | 38 | 39 | 38 | 38 |
| Optical characteristics | | Haze(%) | 9.8 | 8.8 | 8.4 | 10.8 |
| | | Total light transmittance (%) | 87 | 87 | 87 | 89 |
| Moisture vapor transmission rare (g/m$^2$/24 hr) | | | 33 | 37 | 6 | 37 |
| Module evaluation | | Filling-up power generation portion clearance | ◎ | ◎ | ◎ | ◎ |
| | | Creep resistance | ◎ | ◎ | ◎ | ◎ |

[Table 3]

| | Ex 9 | Ex 10 | Ex. 11 | Ex 12 |
|---|---|---|---|---|
| Layer constitution | 2 Types 3 layers | 2 Types 3 layers | 2 Types 3 layers | 3 Types 5 layers |

(continued)

| | | | Ex 9 | Ex 10 | Ex. 11 | Ex 12 |
|---|---|---|---|---|---|---|
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR--5.7, mp=72˚C | VA=28 wt% MFR=5.7, mp=72˚C | VA=28 wt%, MFR=5.7, mp=72˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 10 | 10 | 10 | 65 |
| | Base layer | Resin | | Ethylene-vinyl acetate copolymer | Ethylene-vinyl acetate copolymer | Ethylene-vinyl acetate copolymer | Linear low density polyethylene |
| | | | Physical properties | VA=28 wt%, MFR=5.7, mp=72˚C | VA=28 wt%, MFR=5.7, mp=72˚C | VA=28 wt% MFR=5.7, mp=72˚C | $\rho$=0.900 g/cm$^3$, MFR=4.0, mp=95˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 80 | 80 | 80 | 25 |
| | Core layer | Resin | | Cyclic polyolefin copolymer | Amorphous copolyester | Nylon 12 | Ethylene-propylene copolymer |
| | | | Physical properties | $\rho$=1.020/cm$^3$ | $\rho$=1.270/cm$^3$ | $\rho$=1.030 g/cm$^3$, mp=145˚C | $\rho$=0.876 g/cm$^3$, MFR=2.0 |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 10 | 10 | 10 | 10 |
| Sheet thickness | | | | 450 $\mu$m | 450 $\mu$m | 450 $\mu$m | 450 $\mu$m |
| Cross-linking method | | | | | | | |

(continued)

|  |  |  | Ex 9 | Ex 10 | Ex. 11 | Ex 12 |
|---|---|---|---|---|---|---|
|  | Ionizing radiation irradiation conditions |  |  |  |  |  |
|  |  | Apparatus | EPS-800 | EPS-800 | EPS-800 | EPS-800 |
|  |  | Acceleration voltage | 500 kV | 500kV | 500kV | 500 kV |
|  |  | Irradiation density | 30 kGy | 30 kGy | 30 kGy | 30 kGy |
|  | Organic peroxide |  | - | - | - | - |
|  |  | Blending ratio to sealing sheet | - | - | - | - |
| Gel fraction |  | All layer gel fraction(%) Surface layer gel fraction (%) | 28 38 | 29 38 | 29 38 | 32 38 |
| Optical characteristics |  | Haze (%) | 8.5 | 9.2 | 9.4 | 9.5 |
|  |  | Total light transmittance (%) | 88 | 86 | 86 | 84 |
| Moisture vapor transmission rate (g/m$^2$/24 hr) |  |  | 1 | 3 | 5 | 33 |
| Module evaluation |  | Filling-up power generation portion clearance | ◎ | ◎ | ◎ | ◎ |
|  |  | Creep resistance | ◎ | ◎ | ◎ | ◎ |

[Table 4]

|  | Ex. 13 | Ex. 14 | Ex. 15 | Ex. 16 |
|---|---|---|---|---|
| Layer constitution | 3 Types 5 layers | 3 Types 5 layers | 3 Types 5 layers | 3 Types 5 layers |

(continued)

| | | | | Ex. 13 | Ex. 14 | Ex. 15 | Ex. 16 |
|---|---|---|---|---|---|---|---|
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt% MFR=5.7, mp=72˚C | VA=28 wt% MFR=5.7, mp=72˚C | VA=28 wt%, MFR=5.7, mp=72˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 6 | 30 | 20 | 10 |
| | Base layer | Resin | | Linear low density polyethylene | Linear ultra-low density polyethylene | Linear ultra-low density polyethylene | Linear ultra-low density polyethylene |
| | | | Physical properties | $\rho$=0.900 g/cm$^3$, MFR=4.0, mp=95˚C | $\rho$=0.863 g/cm$^3$, MFR=0.5, mp=47˚C | $\rho$=0.863 g/cm$^3$, MFR=0.5, mp=47˚C | $\rho$=0.863 g/cm$^3$, MFR=0.5, mp=47˚C |
| | | | Ratio | 100 wt% | 100 wt% | 100 wt% | 100 wt% |
| | | Resin | | - | - | - | - |
| | | | Physical properties | | | | - |
| | | | Ratio | - | - | - | - |
| | | Thickness ratio | | 84 | 60 | 70 | 80 |
| | Core layer | Resin | | Polypropylene | Cyclic polyolefin copolymer | Amorphous copolyester | Nylon 12 |
| | | | Physical properties | $\rho$=0,900 g/cm$^3$, MFR=0.4, mp=165˚C | $\rho$=1.020/cm$^3$ | $\rho$=1.270/cm$^3$ | $\rho$=1.030 g/cm$^3$, mp=145˚C |
| | | | Ratio | 100 wt% | 100 wt% | 100 wt% | 100 wt% |
| | | Resin | | - | - | - | - |
| | | | Physical properties | - | - | - | - |
| | | | Ratio | - | - | - | - |
| | | Thickness ratio | | 10 | 10 | 10 | 10 |
| Sheet thickness | | | | 450 $\mu$m | 450 $\mu$m | 450 $\mu$m | 450 $\mu$m |
| Cross-linking method | | | | | | | |

(continued)

| | | | Ex. 13 | Ex. 14 | Ex. 15 | Ex. 16 |
|---|---|---|---|---|---|---|
| | Ionizing radiation irradiation conditions | | | | | |
| | | Apparatus | EPS-800 | EPS-800 | EPS-800 | EPS-800 |
| | | Acceleration voltage | 500 kV | 500 kV | 500 kV | 500 kV |
| | | Irradiation density | 30 kGy | 30 kGy | 30 kGy | 30 kGy |
| | Organic peroxide | | - | - | - | - |
| | | Blending ratio to sealing sheet | - | - | - | - |
| Gel fraction | | All layer gel fraction (%) | 28 | 30 | 31 | 30 |
| | | Surface layer gel fraction (%) | 43 | 40 | 40 | 41 |
| Optical characteristics | | Haze (%) | 12.8 | 9.2 | 9.8 | 9.9 |
| | | Total light transmittance (%) | 84 | 85 | 84 | 84 |
| Moisture vapor transmission rate (g/m$^2$/24 hr) | | | 37 | 16 | 16 | 21 |
| Module evaluation | | Filling-up power generation portion clearance | ◎ | ◎ | ◎ | ◎ |
| | | Creep resistance | ◎ | ◎ | ◎ | ◎ |

[Table 5]

| | Ex. 17 | Ex. 18 | Ex. 19 | Ex 20 |
|---|---|---|---|---|
| Layer constitution | 3 Types 5 layers | 3 Types 5 layers | 3 Types 5 layers | 3 Types 5 layers |

(continued)

| | | | Ex. 17 | Ex. 18 | Ex. 19 | Ex 20 |
|---|---|---|---|---|---|---|
| Surface layer | Resin | | Ethylene-vinyl acetate copolymer | Ethylene-vinyl acetate copolymer | Ethylene-vinyl acetate copolymer | Ethylene-vinyl acetate copolymer |
| | | Physical properties | VA=28 wt%, MFR=5.7, mp=72˚C | VA=28 wt%, MFR=5.7, mp=72˚C | VA=28 wt%, MFR=3.7, mp=72˚C | VA=28 wt%, MFR=5.7, mp=72˚C |
| | | Ratio | 100 wt% | 95 wt% | 70 wt% | 100 wt% |
| | Resin | | - | Saponified ethylene-vinyl acetate copolymer | Saponified ethylene-vinyl acetate copolymer | - |
| | | Physical properties | - | Saponification degree 40%, MFR=16, mp=100˚C | Saponification degree 40%, MFR=16, ny=100˚C | - |
| | | Ratio | - | 5 wt% | 30 wt% | - |
| | Thickness ratio | | 10 | 10 | 20 | 20 |
| Base layer | Resin | | Styrene-butadiene copolymer | Ethylene-vinyl acetate copolymer | Ethylene-vinyl acetate copolymer | Linear low density polyethylene |
| | | Physical properties | $\rho$=0.990 g/cm$^3$, MFR=2.7 | VA=28 wt%, MFR=5.7, mp=72˚C | VA=28 wt%, MFR=5.7, mp=72˚C | $\rho$=900 g/cm$^3$, MFR=4.0, mp=95˚C |
| | | Ratio | 100 wt% | 100 wt% | 100 wt% | 100 wt% |
| | Resin | | - | - | - | - |
| | | Physical properties | - | - | - | - |
| | | Ratio | - | - | - | - |
| | Thickness ratio | | 60 | 70 | 60 | 60 |
| Core layer | Resin | | Ethylene-propylene copolymer | Ethylene-propylene copolymer | Ethylene-propylene copolymer | Cyclic polyolefin copolymer |
| | | Physical properties | $\rho$=0.876 g/cm$^3$, MFR=2.0 | $\rho$=0.876 g/cm$^3$, MFR=2.0 | $\rho$=0.876 g/cm$^3$, MFR=2.0 | $\rho$=1.020 g/cm$^3$ |
| | | Ratio | 100 wt% | 100 wt% | 100 wt% | 100 wt% |
| | Resin | | - | - | - | - |
| | | Physical properties | - | - | . | - |
| | | Ratio | - | - | - | - |
| | Thickness ratio | | 30 | 20 | 20 | 20 |

(continued)

| | | | Ex. 17 | Ex. 18 | Ex. 19 | Ex 20 |
|---|---|---|---|---|---|---|
| Sheet thickness | | | 450 μm | 450 μm | 450 μm | 450 μm |
| Cross-linking method | | | | | | |
| | Ionizing radiation irradiation conditions | | | | | |
| | | Apparatus | EPS-800 | EPS-800 | EPS-800 | EPS-300 |
| | | Acceleration voltage | 500 kV | 500kV | 500 kV | 150 kV |
| | | Irradiation density | 30kGy | 30 kGy | 30kGy | 100 kGy |
| | Organic peroxide | | - | - | - | - |
| | | Blending ratio to sealing sheet | - | - | - | - |
| Gel fraction | | All layer gel fraction (%) | 26 | 25 | 23 | 12 |
| | | Surface layer gel fraction (%) | 41 | 38 | 40 | 51 |
| Optical characteristics | | Haze (%) | 9.5 | 8.8 | 9 | 9.4 |
| | | Total light transmittance (%) | 85 | 87 | 86 | 85 |
| Moisture vapor transmission rate (g/m$^2$/24hr) | | | 6 | 6 | 6 | 16 |
| Module evaluation | | Filling-up power generation portion clearance | ◎ | ◎ | ◎ | ◎ |
| | | Creep resistance | ◎ | ◎ | ◎ | ○ |

[Table 6]

| | Ex. 21 | Ex. 22 | Ex. 23 |
|---|---|---|---|
| Layer constitution | 3 Types 5 layers | 2 Types 3 layers | 2 Types 2 layers |

(continued)

| | | | | Ex. 21 | Ex. 22 | Ex. 23 | |
|---|---|---|---|---|---|---|---|
| | Surface layer | Resin | | Ethylene-vinyl acetate copolymer | Ethylene-vinyl acetate copolymer | Ethylene-vinyl acetate copolymer | Ethylene-ethyl acrylate copolymer |
| | | | Physical properties | VA=28 wt%, MFR=5.7, mp=72˚C | VA=28 wt%, MFR=5.7, mp=72˚C | VA=28 wt%, MFR=15, mp=71˚C | EA=25 wt%, MFR=5 |
| | | | Ratio | 100 wt% | 100 wt% | 100 wt% | 100 wt% |
| | | Resin | | - | - | Silane coupling agent | Silane coupling agent |
| | | | Physical properties | - | - | KBM503 (Shin-Etsu Chemical Co., Ltd.) | KBM503 (Shin-Etsu Chemical Co., Ltd.) |
| | | | Ratio | - | - | 0.5 wt% | 0.5 wt% |
| | | Thickness ratio | | 10 | 10 | 10 | 34 |
| | Base layer | Resin | Physical properties | Linear ultra-low density polyethylene g/cm³, MFR=0.5, | Ethylene-vinyl acetate copolymer VA=28 wt%, MFR=5.7, mp=72˚C | Ethylene-vinyl acetate copolymer VA=28 wt%, MFR=15, mp=71˚C | |
| | | | Ratio | ρ=0.863 mp=47˚C 100 wt% | 100 wt% | 100 wt% | |
| | | Resin | | - | - | Silane coupling agent | |
| | | | Physical properties | - | - | KBM503 (Shin-Etsu Chemical Co., Ltd.) | |
| | | | Ratio | - | - | 0.5 wt% | |
| | | Thickness ratio | | 86 | 60 | 56 | |
| | Core layer | Resin | | Polypropylene | Linear ultra-low density polyethylene | - | |
| | | | Physical properties | ρ=0.900 g/cm³, MFR=0.4, mp=165˚C | ρ=0.863 g/cm³, MFR=0.5, mp=47˚C | - | |
| | | | Ratio | 100 wt% | 100 wt% | - | |
| | | Resin | | - | - | | |
| | | | Physical properties | - | - | - | |
| | | | Ratio | - | - | - | |
| | | Thickness ratio | | 4 | 30 | | |

(continued)

|  |  |  | Ex. 21 | Ex. 22 | Ex. 23 |
|---|---|---|---|---|---|
| Sheet thickness |  |  | 450 μm | 450 μm | 600 μm |
| Cross-linking method |  |  |  |  |  |
|  | Ionizing radiation irradiation conditions |  |  |  |  |
|  |  | Apparatus | EPS-300 | - | - |
|  |  | Acceleration voltage | 175 kV | - | - |
|  |  | Irradiation density | 80 kGy | - | . |
|  | Organic peroxide |  | - | 2,5 Dimethyl 2,5(t-butylperoxy) hexane | 2,5 Dimethyl 2,5(t-butylperoxy)hexane |
|  |  | Blending ratio to sealing sheet | - | 1 wt% | 1.5 wt% |
| Gel fraction |  | All layer gel fraction (%) | 10 | 90 | 83 |
|  |  | Surface layer gel fraction (%) | 60 | 90 | 83 |
| Optical characteristics |  | Haze(%) | 10.2 | 8.0 | 8.6 |
|  |  | Total light transmittance(%) | 85 | 89 | 88 |
| Moisture vapor transmission rate (g/m$^2$/24 hr) |  |  | 16 | 21 | 42 |
| Module evaluation |  | Filling-up power generation portion clearance | ◎ | ◎ | ◎ |
|  |  | Creep resistance | ○ | ◎ | ◎ |

[Table 7]

|  | Com. Ex. 1 | Com. Ex. 2 | Com. Ex. 3 |
|---|---|---|---|
| Layer constitution | Single layer | Single layer | Single layer |

(continued)

| | | | | Com. Ex. 1 | Com. Ex. 2 | Com. Ex. 3 |
|---|---|---|---|---|---|---|
| | Surface layer | Resin | | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28 wt%, MFR=5.7, mp=72˚C |
| | | | Ratio | 100 wt% | 100 wt% | 100 wt% |
| | | Additive | | - | - | - |
| | | | | - | - | - |
| | | | | - | - | |
| | | Thickness ratio | | 10 | 10 | 10 |
| | Base layer | Resin | | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28 wt%, MFR=5.7, mp=72˚C |
| | | | Ratio | 100 wt% | 100 wt% | 100 wt% |
| | | Additive | | - | - | - |
| | | | Physical properties | - | - | - |
| | | | Ratio | - | - | - |
| | | Thickness ratio | | 80 | 80 | 80 |
| | Core layer | Resin | | Ethylene-vinyl acetate copolymer | Ethyleno-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28 wt%, MFR=5.7, mp=72˚C |
| | | | Ratio | 100 wt% | 100 wt% | 100 wt% |
| | | Additive | | - | - | - |
| | | | Physical properties | - | - | - |
| | | | Ratio | - | - | - |
| | | Thickness ratio | | 10 | 10 | 10 |
| Sheet thickness | | | | 450 μm | 450 μm | 450 μm |
| Cross-linking method | | | | | | |

(continued)

|  |  |  | Com. Ex. 1 | Com. Ex. 2 | Com. Ex. 3 |
|---|---|---|---|---|---|
|  | Ionizing radiation irradiation conditions |  |  |  |  |
|  |  | Apparatus | - | EPS-800 | - |
|  |  | Acceleration voltage | - | 500 kV | - |
|  |  | Irradiation density | - | 100 kGy | - |
|  | Organic peroxide |  | - | - | 2,5 Dimethyl 2,5 (t-butylperoxy) hexane |
|  |  | Blending ratio to sealing sheet | - | - | 1.5 wt% |
| Gel fraction |  | All layer gel fraction (%) | 0 | 81 | 90 |
|  |  | Surface layer gel fraction (%) | 0 | 85 | 90 |
| Optical characteristics |  | Haze (%) | 8.5 | 8.5 | 8.5 |
|  |  | Total light transmittance (%) | 89 | 89 | 89 |
| Moisture vapor transmission rate (g/m$^2$/24/hr) |  |  | 84 | 84 | 84 |
| Module evaluation |  | Filling-up power generation portion clearance | ◎ | × | ◎ |
|  |  | Creep resistance | × | ◎ | ◎ |
| Recyclability evaluation |  |  | ◎ | ◎ | × |

[Table 8]

|  | Ex. 8 | Ex. 13 | Ex. 20 | Ex. 21 |
|---|---|---|---|---|
| Recyclability | ○ | ○ | ◎ | ◎ |

As shown in Tables 1 to 7, the sealing resin sheets of Examples 1 to 23 provided practically good evaluation results for the optical characteristics and moisture vapor transmission rate; when solar cell modules were prepared to perform evaluation of filling-up solar cell power generation portion clearance and creep resistance evaluation, all of the modules provided good evaluation results. Thus, the sealing resin sheets were confirmed to have a low moisture vapor transmission rate while maintaining transparency and creep resistance.

The sheets of Examples 20 and 21 were slightly inferior to those in the other Examples in the creep resistance test. These are probably because although the former sheets were cross-linked with ionizing radiation, the internal layers thereof were made uncross-linked by controlling the acceleration voltage.

In addition, as shown in Table 8, the sheets of Examples 8, 13, 20, and 21 were confirmed to have recyclability while maintaining transparency, creep resistance and a low moisture vapor transmission rate.

The sheets of Examples 20 and 21 were each confirmed to be peeled and separated at a temperature of the melting point or higher because the internal layer thereof was uncross-linked as described above. The sheets of Examples 8 and 13 were each confirmed to be peeled and separated at a temperature of the melting point or higher because the core layer of the internal layer was polypropylene resin and thus not cross-linked with electron rays or the like.

As shown in Table 7, the sealing resin sheet in Comparative Example 1 prepared from ethylene-vinyl acetate copolymer produced the creep between this and the other glass in a thermostat set at 85˚C. The sheet in Comparative Example 2 in which the gel fraction was made 80% or more by subjecting ethylene-vinyl acetate copolymer to cross-linking treatment produced clearance on the periphery of the single-crystal silicon cell. The sheet in Comparative Example 3 had a high moisture vapor transmission rate, and could not prevent a silicon cell as a power generation section and its peripheral member in the solar cell module from exposure to externally entering moisture over a long period of time.

[Examples 24 to 34]

Using resin materials as shown in Tables 9 to 11, sealing resin sheets were prepared according to each condition. The saponified ethylene-vinyl acetate copolymers shown in these Tables were those obtained by saponifying ethylene-vinyl acetate copolymer having a VA % of 28% by mass and an MFR of 5.7 g/10 min. (Ultracene, from Tosoh Corporation).

The saponification degree, MFR, and melting point of the saponified ethylene-vinyl acetate copolymers are shown in Tables 9 to 11 below.

The sealing resin sheets were subjected to electron ray cross-linking treatment according to the "irradiation conditions" shown in Tables 9 to 11 below.

In Example 34, an organic peroxide was used as a cross-linking agent.

Each of the sealing resin sheets was evaluated for gel fraction and optical characteristics.

Using a glass for solar cells as a power generation surface member, a solar cell module was prepared to evaluate the temperature humidity cycle and storage stability.

The evaluation results are shown in Tables 9 to 11.

[Example 35]

The same sealing resin sheet as that prepared in Example 24 was produced.

In a solar cell module for measurement, a polycarbonate resin plate was used as a power generation surface member. Specifically, a solar cell module prepared by piling up a polycarbonate resin plate (Iupilon from Teijin DuPont, 3 mm thick)/ the sealing resin sheet/a power generation portion (single-crystal silicon cell (250 $\mu$m thick))/the sealing resin sheet/a backsheet for solar cells (from Toyo Aluminium K.K.) in that order and vacuum laminating this at 130°C using Model LM50 (from NPC) as a vacuum lamination apparatus was used as a sample for temperature humidity cycle evaluation.

For storage stability evaluation and evaluation of the haze and total light transmittance rate, a sample for evaluation was prepared at a lamination temperature of 130°C using a polycarbonate resin plate as a power generation surface member.

The other conditions were evaluated as described in Examples 24 to 34. The evaluation results are shown in Table 11.

[Example 36]

The same sealing resin sheet as that prepared in Example 24 was produced.

Subsequently, this sealing resin sheet was used to prepare a composite material.

Using two white tempered plate glasses (glass for solar cells from AGC Fabritech Co., Ltd., 3 mm thick), a composite material was prepared by piling up the white tempered plate glass/ the sealing resin sheet/the white tempered plate glass in that order and laminating these at 130°C and used as a sample for evaluation.

When evaluated for transparency, the composite material was practically sufficiently good.

The composite material was stored in an environment of a temperature of 40°C and a humidity of 85% for 2 weeks without applying edge face treatment for preventing moisture absorption between the glasses; thereafter, when it was evaluated for the appearance thereof, no change in the appearance was identified with no observation of whitening or peeling, confirming that degradation due to humidity could be effectively prevented.

[Example 37]

The same sealing resin sheet as that prepared in Example 24 was produced.

Subsequently, this sealing resin sheet was used to prepare a composite material.

In this example, using a white tempered plate glass (glass for solar cells from AGC Fabritech Co., Ltd.,) and an acrylic resin plate (Delaglass, from Asahikasei Technoplus Co., Ltd.), the white tempered plate glass (3 mm thick)/ the sealing resin sheet/the acrylic resin plate (3 mm thick) were piled up in that order, laminated at 130°C, and used as a sample for evaluation.

[Example 38]

The same sealing resin sheet as that prepared in Example 24 was produced.

Subsequently, this sealing resin sheet was used to prepare a composite material.

In this example, using a white tempered plate glass (glass for solar cells from AGC Fabritech Co., Ltd.,) and a polycarbonate resin plate (Iupilon from Teijin DuPont), the white tempered plate glass (3 mm thick)/ the sealing resin sheet/the polycarbonate resin plate (3 mm thick) were piled up in that order, laminated at 130˚C, and used as a sample for evaluation.

When evaluated for transparency, the composite materials of Examples 37 and 38 were practically sufficiently good.

The composite material was stored in an environment of a temperature of 40˚C and a humidity of 85% for 2 weeks without applying edge face treatment for preventing moisture absorption between the glass and the resin; thereafter, when it was evaluated for the appearance thereof, no change in the appearance was identified with no observation of whitening or peeling, confirming that degradation due to humidity could be effectively prevented.

[Comparative Examples 4 to 7]

Using resin materials as shown in Table 12, sealing resin sheets were prepared according to each condition. The sealing resin sheets were subjected to electron ray cross-linking treatment according to the "irradiation conditions" shown in Table 12 below.

Each of the sealing resin sheets was evaluated for gel fraction and optical characteristics.

Using a glass for solar cells as a power generation surface member, a solar cell module was prepared to evaluate the temperature humidity cycle and storage stability. The evaluation results are shown in Table 12.

The unit of MFR given in Tables 9 to 12 below is g/10 min.

[Table 9]

| | | | | Ex 24 | Ex 25 | Ex 26 | Ex 27 |
|---|---|---|---|---|---|---|---|
| Layer constitution | | | | | | | |
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72°C | VA=28 wt%, MFR=5.7, mp=72°C | VA=28 wt%, MFR=5.7, mp=72°C | VA=28 wt%, MFR=5.7, mp=72°C |
| | | | Ratio | 95 wt% | 50 wt% | 95 wt% | 95 wt% |
| | | Resin | | Saponified ethylene-vinyl acetate copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 10%, MFR=16, mp=100°C | Saponification degree 70%, MFR=16, mp=100°C |
| | | | Ratio | 5 wt% | 50 wt% | 5 wt% | 5 wt% |
| | | Layer ratio | | 5% | 5% | 5% | 5% |
| | | Hydroxyl group amount (wt%) | | 0.56% | 5.6% | 0.14% | 0.98% |
| | Internal layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72°C | VA=28 wt%, MFR=5.7, mp=72°C | VA=28 wt%, MFR=5.7, mp=72°C | VA=28 wt%, MFR=5.7, mp=72°C |
| | | | Ratio | 95 wt% | 50 wt% | 95 wt% | 95 wt% |
| | | Resin | | Saponified ethylene-vinyl acetate copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 10%, MFR=16, mp=100°C | Saponification degree 70%, MFR=16, mp=100°C |
| | | | Ratio | 5 wt% | 50 wt% | 5 wt% | 5 wt% |
| | | Layer ratio | | 90% | 90% | 90% | 90% |
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72°C | VA=28 wt%, MFR=5.7, mp=72°C | VA=28 wt%, MFR=5.7, mp=72°C | VA=28 wt%, MFR=5.7, mp=72°C |
| | | | Ratio | 95 wt% | 50 wt% | 95 wt% | 95 wt% |
| | | Resin | | Saponified ethylene-vinyl acetate copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 10%, MFR=16, mp=100°C | Saponification degree 70%, MFR=16, mp=100°C |
| | | | Ratio | 5 wt% | 50 wt% | 5 wt% | 5 wt% |
| | | Layer ratio | | 5% | 5% | 5% | 5% |
| | | Hydroxyl group amount (wt%) | | 0.56% | 5.6% | 0.14% | 0.98% |
| Organic peroxide | | | | - | - | - | - |
| | Bleeding ratio to sealing resin sheet | | | - | - | - | - |
| Sheet thickness | | | | 450 μm | 450 μm | 450 μm | 450 μm |
| Irradiation conditions | | | | | | | |
| | Apparatus | | | EPS-800 | EPS-800 | EPS-800 | EPS-800 |
| | Acceleration voltage | | | 500 kV | 500 kV | 500 kV | 500 kV |
| | Irradiation density | | | 30 kGy | 30 kGy | 30 kGy | 30 kGy |
| Gel fraction | | | | | | | |
| | All layer gel fraction (wt%) | | | 41 | 28 | 41 | 39 |
| | Gel fraction of layer contacting material to be sealed (wt%) | | | 40 | 26 | 40 | 38 |
| Optical characteristics | | | | | | | |
| | Haze (%) | | | 8.6 | 9.6 | 8.5 | 15 |
| | Total light transmittance (%) | | | 87 | 82 | 88 | 78 |
| Module evaluation | | | | | | | |
| | Power generation surface member | | | Glass plate for solar cell (3 mm thick) | Glass plate for solar cell (3 mm thick) | Glass plate for solar cell (3 mm thick) | Glass plate for solar cell (3 mm thick) |
| | Temperature humidity cycle | | Appearance | ◎ | ◎ | ◎ | ◎ |
| | Storage stability evaluation | | Peeling | ◎ | ◎ | ◎ | ◎ |

[Table 10]

| | | | | Ex. 28 | Ex. 29 | Ex. 30 | Ex. 31 |
|---|---|---|---|---|---|---|---|
| Layer constitution | | | | | | | |
| | Surface layer | Resin | | Ethylene-vinyl acetate copolymer | Ethylene-vinyl acetate copolymer | Ethylene-acrylic acid copolymer | Linear ultra-low density polyethylene |
| | | | Physical properties | VA=28 wt%, MFR=5.7, mp=72°C | VA=28 wt%, MFR=5.7, mp=72°C | ρ=0.932 g/cm³, MFR=5.5, mp=99°C | ρ=0.863 g/cm³, MFR=0.5, mp=47°C |
| | | | Ratio | 95 wt% | 95 wt% | 95 wt% | 95 wt% |
| | | Resin | | Saponified ethylene-vinyl acetate-acrylate ester copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 40%, MFR=16, mp=100°C | Saponification degree 10%, MFR=16, mp=100°C |
| | | | Ratio | 5 wt% | 5 wt% | 5 wt% | 5 wt% |
| | | Layer ratio | | 5% | 5% | 5% | 5% |
| | | Hydroxyl group amount (wt%) | | 0.56% | 0.56% | 0.56% | 0.56% |
| | Internal layer | Resin | | Ethylene-vinyl acetate copolymer | Ethylene-vinyl acetate copolymer | Ethylene-acrylic acid copolymer | Linear ultra-low density polyethylene |
| | | | Physical properties | VA=28 wt%, MFR=5.7, mp=72°C | VA=28 wt%, MFR=5.7, mp=72°C | ρ=0.932 g/cm³, MFR=5.5, mp=99°C | ρ=0.863 g/cm³, MFR=0.5, mp=47°C |
| | | | Ratio | 95 wt% | 100 wt% | 100 wt% | 100 wt% |
| | | Resin | | Saponified ethylene-vinyl acetate-acrylate ester copolymer | | | |
| | | | Physical properties | Saponification degree 40%, MFR=16, mp=100°C | | | |
| | | | Ratio | 5 wt% | | | |
| | | Layer ratio | | 90% | 90% | 90% | 90% |
| | Surface layer | Resin | | Ethylene-vinyl acetate copolymer | Ethylene-vinyl acetate copolymer | Ethylene-acrylic acid copolymer | Linear ultra-low density polyethylene |
| | | | Physical properties | VA=28 wt%, MFR=5.7, mp=72°C | VA=28 wt%, MFR=5.7, mp=72°C | ρ=0.932 g/cm³, MFR=5.5, mp=99°C | ρ=0.863 g/cm³, MFR=0.5, mp=47°C |
| | | | Ratio | 95 wt% | 95 wt% | 95 wt% | 95 wt% |
| | | Resin | | Saponified ethylene-vinyl acetate-acrylate ester copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 40%, MFR=16, mp=100°C | Saponification degree 10%, MFR=16, mp=100°C |
| | | | Ratio | 5 wt% | 5 wt% | 5 wt% | 5 wt% |
| | | Layer ratio | | 5% | 5% | 5% | 5% |
| | | Hydroxyl group amount (wt%) | | 0.56% | 0.56% | 0.56% | 0.56% |
| Organic peroxide | | | | - | - | - | - |
| | Bleeding ratio to sealing resin sheet | | | - | - | - | - |
| Sheet thickness | | | | 450 μm | 450 μm | 450 μm | 450 μm |
| Irradiation conditions | | | | | | | |
| | Apparatus | | | EPS-800 | EPS-800 | EPS-800 | EPS-800 |
| | Acceleration voltage | | | 500 kV | 500 kV | 500 kV | 500 kV |
| | Irradiation density | | | 30 kGy | 30 kGy | 30 kGy | 30 kGy |
| Gel fraction | | | | | | | |
| | All layer gel fraction (wt%) | | | 38 | 42 | 32 | 25 |
| | Gel fraction of layer contacting material to be sealed (wt%) | | | 37 | 40 | 31 | 24 |
| Optical characteristics | | | | | | | |
| | Haze (%) | | | 9.0 | 8.5 | 8.8 | 8.6 |
| | Total light transmittance (%) | | | 83 | 88 | 88 | 89 |
| Module evaluation | | | | | | | |
| | Power generation surface member | | | Glass plate for solar cell (3 mm thick) | Glass plate for solar cell (3 mm thick) | Glass plate for solar cell (3 mm thick) | Glass plate for solar cell (3 mm thick) |
| | Temperature humidity cycle | Appearance | | ◎ | ◎ | ◎ | ◎ |
| | Storage stability evaluation | Peeling | | ◎ | ◎ | ◎ | ◎ |

[Table 11]

| | | | | Ex. 32 | Ex. 33 | Ex. 34 | Ex. 35 |
|---|---|---|---|---|---|---|---|
| Layer constitution | | | | | | | |
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=27 wt%, MFR=23, mp=72°C | VA=27 wt%, MFR=13, mp=72°C | VA=28 wt%, MFR=5.7, mp=72°C | VA=28 wt%, MFR=5.7, mp=72°C |
| | | | Ratio | 95 wt% | 95 wt% | 97 wt% | 95 wt% |
| | | Resin | | Saponified ethylene-vinyl acetate copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 40%, MFR=16, mp=100°C | Saponification degree 40%, MFR=16, mp=100°C |
| | | | Ratio | 5 wt% | 5 wt% | 3 wt% | 5 wt% |
| | | Layer ratio | | 5% | 5% | 5% | 5% |
| | | Hydroxyl group amount (wt%) | | 0.56% | 0.56% | 0.34% | 0.56% |
| | Internal layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=27 wt%, MFR=23, mp=72°C | VA=27 wt%, MFR=13, mp=72°C | VA=28 wt%, MFR=5.7, mp=72°C | VA=28 wt%, MFR=5.7, mp=72°C |
| | | | Ratio | 100 wt% | 95 wt% | 98 wt% | 95 wt% |
| | | Resin | | | Saponified ethylene-vinyl acetate copolymer | Saponified ethylene-vinyl acetate copolymer | Saponified ethylene-vinyl acetate copolymer |
| | | | Physical properties | | Saponification degree 40%, MFR=16, mp=100°C | Saponification degree 40%, MFR=16, mp=100°C | Saponification degree 40%, MFR=16, mp=100°C |
| | | | Ratio | | 5 wt% | 1 wt% | 5 wt% |
| | | Layer ratio | | 90% | 90% | 90% | 90% |
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=27 wt%, MFR=23, mp=72°C | VA=27 wt%, MFR=13, mp=72°C | VA=28 wt%, MFR=5.7, mp=72°C | VA=28 wt%, MFR=5.7, mp=72°C |
| | | | Ratio | 95 wt% | 95 wt% | 97 wt% | 95 wt% |
| | | Resin | | Saponified ethylene-vinyl acetate copolymer | Saponified ethylene-vinyl acetate copolymer | Saponified ethylene-vinyl acetate copolymer | Saponified ethylene-vinyl acetate copolymer |
| | | | Physical properties | Saponification degree 40%, MFR=16, mp=100°C | Saponification degree 40%, MFR=16, mp=100°C | Saponification degree 40%, MFR=16, mp=100°C | Saponification degree 40%, MFR=16, mp=100°C |
| | | | Ratio | 5 wt% | 5 wt% | 3 wt% | 5 wt% |
| | | Layer ratio | | 5% | 5% | 5% | 5% |
| | | Hydroxyl group amount (wt%) | | 0.56% | 0.56% | 0.34% | 0.56% |
| Organic peroxide | | | | - | - | 1,1-Bis(t-butylperoxy)3,3,5-trimethylcyclohexane | - |
| | Bleeding ratio to sealing resin sheet | | | - | - | 1 wt% | - |
| Sheet thickness | | | | 450 μm | 450 μm | 450 μm | 450 μm |
| Irradiation conditions | | | | | | | |
| | Apparatus | | | EPS-800 | EPS-300 | - | EPS-800 |
| | Acceleration voltage | | | 500 kV | 150 kV | - | 500 kV |
| | Irradiation density | | | 80 kGy | 100 kGy | - | 30 kGy |
| Gel fraction | | | | | | | |
| | All layer gel fraction (wt%) | | | 58 | 7 | 90 | 41 |
| | Gel fraction of layer contacting material to be sealed (wt%) | | | 56 | 27 | 90 | 40 |
| Optical characteristics | | | | | | | |
| | Haze (%) | | | 8.4 | 8.5 | 8.6 | 8.5 |
| | Total light transmittance (%) | | | 89 | 89 | 87 | 88 |
| Module evaluation | | | | | | | |
| | Power generation surface member | | | Glass plate for solar cell (3 mm thick) | Glass plate for solar cell (3 mm thick) | Glass plate for solar cell (3 mm thick) | Polycarbonate resin plate (3 mm thick) |
| | Temperature humidity cycle | Appearance | | ◎ | ◎ | ○ | ◎ |
| | Storage stability evaluation | Peeling | | ◎ | ◎ | ○ | ◎ |

[Table 12]

| Layer constitution | | | | Com. Ex 4 | Com. Ex 5 | Com. Ex 6 | Com. Ex 7 |
|---|---|---|---|---|---|---|---|
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72°C | VA=28 wt%, MFR=5.7, mp=72°C | VA=28 wt%, MFR=5.7, mp=72°C | VA=28 wt%, MFR=5.7, mp=72°C |
| | | | Ratio | 99 wt% | 100 wt% | 100 wt% | 99 wt% |
| | | Resin | | 3-Methacryloxypropyltrimethoxysilane | | | 3-Methacryloxypropyltrimethoxysilane |
| | | | Physical properties | (Shin-Etsu Chemical Co., Ltd. KBM503) | | | (Shin-Etsu Chemical Co., Ltd. KBM503) |
| | | | Ratio | 1 wt% | | | 1 wt% |
| | | Layer ratio | | 5% | 5% | 5% | 5% |
| | | Hydroxyl group amount (wt%) | | 0% | 0% | 0% | 0% |
| | Internal layer | Resin | | Ethylene-vinyl acetate copolymer | Ethylene-vinyl acetate copolymer | Zinc ionomer of ethylene-methacrylic acid copolymer | Ethylene-vinyl acetate copolymer |
| | | | Physical properties | VA=27 wt%, MFR=5.7, mp=72°C | VA=27 wt%, MFR=5.7, mp=72°C | Zinc, neutralization degree 21%, MFR=16 | VA=28 wt%, MFR=5.7, mp=72°C |
| | | | Ratio | 99 wt% | 100 wt% | 100 wt% | 99 wt% |
| | | Resin | | 3-Methacryloxypropyltrimethoxysilane | | | 3-Methacryloxypropyltrimethoxysilane |
| | | | Physical properties | (Shin-Etsu Chemical Co., Ltd. KBM503) | | | (Shin-Etsu Chemical Co., Ltd. KBM503) |
| | | | Ratio | 1 wt% | | | 1 wt% |
| | | Layer ratio | | 90% | 90% | 90% | 90% |
| | Surface layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72°C | VA=28 wt%, MFR=5.7, mp=72°C | VA=28 wt%, MFR=5.7, mp=72°C | VA=28 wt%, MFR=5.7, mp=72°C |
| | | | Ratio | 99 wt% | 100 wt% | 100 wt% | 99 wt% |
| | | Resin | | 3-Methacryloxypropyltrimethoxysilane | | | 3-Methacryloxypropyltrimethoxysilane |
| | | | Physical properties | (Shin-Etsu Chemical Co., Ltd. KBM503) | | | (Shin-Etsu Chemical Co., Ltd. KBM503) |
| | | | Ratio | 1 wt% | | | 1 wt% |
| | | Layer ratio | | 5% | 5% | 5% | 5% |
| | | Hydroxyl group amount (wt%) | | 0% | 0% | 0% | 0% |
| Organic peroxide | | | | - | - | - | - |
| | Bleeding ratio to sealing resin sheet | | | - | - | - | - |
| Sheet thickness | | | | 450 μm | 450 μm | 450 μm | 450 μm |
| Irradiation conditions | | | | | | | |
| | Apparatus | | | EPS-800 | EPS-800 | EPS-800 | EPS-800 |
| | Acceleration voltage | | | 500 kV | 500 kV | 500 kV | 500 kV |
| | Irradiation density | | | 30 kGy | 30 kGy | 30 kGy | 30 kGy |
| Gel fraction | | | | | | | |
| | All layer gel fraction (wt%) | | | 58 | 43 | 10 | 58 |
| | Gel fraction of layer contacting material to be sealed (wt%) | | | 56 | 43 | 42 | 56 |
| Optical characteristics | | | | | | | |
| | Haze (%) | | | 8.6 | 8.5 | 8.4 | 8.6 |
| | Total light transmittance (%) | | | 88 | 89 | 88 | 88 |
| Module evaluation | | | | | | | |
| | Power generation surface member | | | Glass plate for solar cell (3 mm thick) | Glass plate for solar cell (3 mm thick) | Glass plate for solar cell (3 mm thick) | Polycarbonate resin plate (3 mm thick) |
| | Temperature humidity cycle | | Appearance | × | × | × | × |
| | Storage stability evaluation | | Peeling | × | ○ | ○ | × |

As shown in Tables 9 to 11, the sealing resin sheets of Examples 24 to 35 provided practically good evaluation results for the optical characteristics; when solar cell modules were prepared to perform temperature humidity cycle evaluation and storage stability evaluation, all of the modules provided good evaluation results.

Specifically, it was demonstrated that the percentage of the hydroxyl group in a resin could be controlled to 0.1 to 10% by mass by adjusting the content of a hydroxyl group-containing olefin-based copolymer in the resin layer to 3 to 60% by mass and making the saponification degree of the copolymer 10 to 70% to ensure compatibility with EVA, produce no whitening or peeling, and effectively prevent the degradation due to humidity.

Example 34 was slightly inferior to the other Examples in the temperature humidity cycle evaluation. This is because the use of a cross-linking agent consisting of an organic peroxide tends to make the cross-linking degree non-uniform and thus produced partial variations in physical properties in the sealing resin sheet. In addition, the organic peroxide not used for cross-linking caused cleavage and changed physical properties with time to make this Example slightly inferior to the other Examples also in the storage stability evaluation.

As shown in Table 12, in Comparative Example 4, the resin constituting the surface layer contained a silane coupling agent for improved adhesion and had a content of the hydroxyl group 0%.

In this example, local peeling was observed in the temperature humidity cycle evaluation of the solar cell module. This is because a silane coupling agent is prone to produce variations in its function depending on the heated state and did not locally function sufficiently because of its partially different heated state.

Resin degradation was also caused, which provide no practically good evaluation result for storage stability.

In Comparative Example 5, peeling was observed in the appearance evaluation after the temperature humidity cycle because of insufficient adhesion due to no olefin-based copolymer having hydroxyl group being contained in the resin of the layer constituting the sealing resin sheet.

In contract, the storage stability was good because no additive causing resin degradation is contained.

In Comparative Example 6, peeling was observed in the appearance evaluation after the temperature humidity cycle because of insufficient adhesion due to no olefin-based copolymer having hydroxyl group being contained in the resin of the layer constituting the sealing resin sheet.

In contract, the storage stability was good because no additive causing resin degradation is contained.

In Comparative Example 7, the layer constituting the sealing resin sheet contained a silane coupling agent and the resin had a content of hydroxyl group of 0%.

In this example, local peeling was observed in the appearance evaluation after the temperature humidity cycle. This is because a silane coupling agent is prone to produce variations in its function depending on the heated state and did not locally function sufficiently because of its partially different heated state.

No practically good evaluation result for storage stability was obtained.

[Examples 39 to 55]

Resins as shown in Tables 13 and 14 were used. Each resin was melted using an extruder; the resin was melt-extruded in the form of a tube through a ring die connected to the extruder; and the tube formed by the melt extrusion was quenched using a water cooling ring to provide each sealing resin sheet described in Tables 13 and 14.

The resultant sealing resin sheets were subjected to electron ray cross-linking treatment according to the conditions described in Tables 13 and 14. The evaluation results of each sealing resin sheet are shown in Tables 1 and 2.

The results of Tables 13 and 14 shows that the resultant sealing resin sheets had excellent characteristics and was very satisfactory.

[Table 13]

| | | | Ex. 39 | Ex. 40 | Ex. 41 | Ex. 42 | Ex. 43 | Ex. 44 | Ex. 45 | Ex. 46 | Ex. 47 |
|---|---|---|---|---|---|---|---|---|---|---|---|
| Resin | | | EVA | EVA | EVA | EVA | EVA | EVA | EVA | EVA | EVA |
| | Physical properties | VA(wt%) | 28 | 20 | 27 | 32 | 33 | 28 | 28 | 27 | 27 |
| | | MI(g/10min) | 5.7 | 1.5 | 13.0 | 1.0 | 30.0 | 5.7 | 5.7 | 13.0 | 23.0 |
| | | Density (g/cm$^3$) | 0.952 | 0.941 | 0.950 | 0.956 | 0.960 | 0.952 | 0.952 | 0.950 | 0.950 |
| | | Tm(˚C) | 72 | 58 | 72 | 63 | 66 | 72 | 72 | 72 | 72 |
| Irradiation conditions | | | | | | | | | | | |
| | Acceleration voltage (kV) | | 500 | 500 | 500 | 500 | 500 | 300 | 800 | 500 | 500 |
| | Irradiation density (kGy) | | 30 | 30 | 30 | 30 | 30 | 50 | 20 | 20 | 50 |
| Cross-linking characteristic | | | | | | | | | | | |
| | Gel fraction (wt%) | | 43.1 | 41.0 | 383 | 42.0 | 42.0 | 41.0 | 40.0 | 13.6 | 58.0 |
| Thickness | | | 450 | 450 | 450 | 450 | 450 | 200 | 600 | 450 | 450 |
| Optical characteristics | | | | | | | | | | | |
| | Haze (%) | | 8.5 | 9.0 | 8.3 | 8.4 | 8.3 | 8.5 | 8.5 | 8.3 | 8.3 |
| | Total light transmittance (%) | | 89 | 85 | 90 | 90 | 90 | 89 | 89 | 90 | 90 |
| Module evaluation | | | | | | | | | | | |
| | Peeling strength between sheet and glass | | ○ | ○ | ○ | ○ | ○ | ○ | ○ | ○ | ○ |
| | Evaluation of filling-up solar cell power generation portion clearance | | ○ | ○ | ○ | ○ | ○ | ○ | ○ | ○ | ○ |
| | Creep resistance evaluation | | ○ | ○ | ○ | ○ | ○ | ○ | ○ | ○ | ○ |

[Table 14]

| | Ex 48 | Ex 49 | Ex. 50 | Ex 51 | Ex. 52 | Ex. 53 | Ex. 54 | Ex. 55 |
|---|---|---|---|---|---|---|---|---|
| Resin | VL | LLDPE | LLDPE | LD | HD | PP | EPC | EAA |

(continued)

| | | | Ex 48 | Ex 49 | Ex. 50 | Ex 51 | Ex. 52 | Ex. 53 | Ex. 54 | Ex. 55 |
|---|---|---|---|---|---|---|---|---|---|---|
| | Physical properties | VA(wt%) | 0 | 0 | 0 | 0 | 0 | 0 | 0 | 0 |
| | | MI(g/10 min) | 0.5 | 2.0 | 4.0 | 0.4 | 0.8 | 0.4 | 5.5 | 5.5 |
| | | Density (g/cm$^3$) | 0.863 | 0.926 | 0.900 | 0.921 | 0.952 | 0.900 | 0.900 | 0.932 |
| | | Tm (˚C) | 47 | 124 | 95 | 120 | 131 | 165 | 133 | 99 |
| Irradiation conditions | | | | | | | | | | |
| | Acceleration voltage (kV) | | 500 | 500 | 500 | 50 | 500 | 500 | 500 | 500 |
| | Irradiation density (kGy) | | 80 | 80 | 80 | 50 | 30 | 80 | 80 | 50 |
| Cross-linking characteristic | | | | | | | | | | |
| | Gel fraction (wt%) | | 26.0 | 25.0 | 28.0 | 38.0 | 23.0 | 12.1 | 16.0 | 33.0 |
| Thickness | | | 450 | 450 | 450 | 450 | 450 | 450 | 450 | 450 |
| Optical characteristics | | | | | | | | | | |
| | Haze (%) | | 8.5 | 8.8 | 8.7 | 8.7 | 9.2 | 8.5 | 8.7 | 8.7 |
| | Total light transmittance (%) | | 90 | 86 | 86 | 86 | 85 | 90 | 88 | 88 |
| Module evaluation | | | | | | | | | | |
| | Peeling strength between sheet and glass | | ○ | ○ | ○ | ○ | ○ | ○ | ○ | ○ |
| | Evaluation of filling-up solar cell power generation portion clearance | | ○ | ○ | ○ | ○ | ○ | ○ | ○ | ○ |
| | Creep resistance evaluation | | ○ | ○ | ○ | ○ | ○ | ○ | ○ | ○ |

[Comparative Examples 8 to 12]

Sealing resin sheets were obtained according to the conditions shown in Table 15 by methods comparable to those of Examples. Thereafter, various evaluations were carried out by methods comparable to those of Examples. The results are shown in Table 15.

The sheet of Comparative Example 8 had a gel fraction of 0% and is not within the scope of the present invention; it produced creep between the other glass plate in a thermostat set at 85˚C because of being not cross-linked.

All of the sheets of Comparative Examples 9 to 12 had a gel fraction of more than 80% and is not within the scope of the present invention; it produced clearance on the periphery of the single-crystal silicon cell.

[Table 15]

| | | | Com. Ex. 8 | Com. Ex. 9 | Com. Ex. 10 | Com. Ex. 11 | Com. Ex. 12 |
|---|---|---|---|---|---|---|---|
| Resin | | | EVA | EVA | VL | LLDPE | LD |
| | Physical properties | VA(wt%) | 28 | 28 | 0 | 0 | 0 |
| | | MI (g/10 min) | 5.7 | 5.7 | 0.5 | 2.0 | 0.4 |
| | | Density (g/cm$^3$) | 0.952 | 0.952 | 0.863 | 0.926 | 0.921 |
| | | Tm (˚C) | 72 | 72 | 47 | 124 | 120 |
| Irradiation conditions | | | | | | | |

(continued)

|  |  | Com. Ex. 8 | Com. Ex. 9 | Com. Ex. 10 | Com. Ex. 11 | Com. Ex. 12 |
|---|---|---|---|---|---|---|
|  | Acceleration voltage (kV) | 0 | 500 | 500 | 500 | 500 |
|  | Irradiation density (kGy) | 0 | 100 | 400 | 400 | 400 |
| Cross-linking characteristic |  |  |  |  |  |  |
|  | Gel fraction (wt%) | 0 | 80.5 | 80.2 | 81.0 | 82.0 |
| Thickness |  | 450 | 450 | 450 | 450 | 450 |
| Optical characteristics |  |  |  |  |  |  |
|  | Haze (%) | 8.5 | 8.5 | 8.5 | 8.8 | 8.7 |
|  | Total light transmittance (%) | 89 | 89 | 90 | 86 | 86 |
| Module evaluation |  |  |  |  |  |  |
|  | Peeling stength between sheet and glass | ○ | ○ | ○ | ○ | ○ |
|  | Evaluation of filling-up solar cell power generation portion clearance | ○ | × | × | × | × |
|  | Creep resistance evaluation | × | ○ | ○ | ○ | ○ |

The resins used in the following Examples 56 to 62 and Comparative Examples 13 and 14 were as follows.

(1) Ethylene-vinyl acetate copolymer
Ultracene 751 from Tosoh Corporation
(2) Saponified ethylene-vinyl acetate copolymer
Melthene 6410 from Tosoh Corporation
(3) Ethylene-methylacrylate copolymer Elvaloy 1218AC from DuPont-Mitsui Chemical Co., Ltd.
(4) Ethylene-ethylacrylate copolymer Elvaloy 2615AC from DuPont-Mitsui Chemical Co., Ltd.

[Examples 56 to 62]

Sealing resin sheets were produced using the materials and composition ratios shown in Tables 16 and 17. Certain resins were melted using two extruders (a surface layer extruder and an internal layer extruder); the resins were melt-extruded in the form of a tube through a ring die connected to the extruders; and the tube formed by the melt extrusion was quenched using a water cooling ring to provide sealing resin sheets shown in each of Examples 56 to 62. The resultant sealing resin sheets of Examples 56 to 62 were subjected to electron ray treatment according to the irradiation conditions shown in the Tables. The sealing resin sheets were evaluated for the all layer gel fraction, haze, total light transmittance rate, adhesion strength to glass, and high humidity resistance. The results are shown in Tables 16 and 17.
Solar cell modules were produced using the resultant sealing resin sheets, and their temperature humidity cycle and storage stability were evaluated. The evaluation results are shown in Tables 16 and 17. Vacuum Laminator for Solar Cells Model LM50 from NPC was used as a vacuum laminator.

[Comparative Examples 13 and 14]

Sealing resin sheets were produced by the same method as in Examples 56 to 62, using the materials and composition ratios shown in Table 17. In introducing an organic peroxide and a silane coupling agent, these additives were each pre-kneaded at a concentration of about 5% in the resin to be introduced and thereby masterbatched, and this materbatch was used by dilution so as to provide a desired blending amount.
The resultant sealing resin sheet of Comparative Example 13 was subjected to electron ray treatment according to the irradiation conditions shown in the Table. The sealing resin sheet was evaluated for the all layer gel fraction, haze, total light transmittance rate, adhesion strength to glass, and high humidity resistance. The results are shown in Table 17.
Solar cell modules were produced using the resultant sealing resin sheets, and their temperature humidity cycle and storage stability were evaluated. The evaluation results are shown in Table 17. Vacuum Laminator for Solar Cells Model LM50 from NPC was used as a vacuum laminator.

[Table 16]

| | | | | Ex. 56 | Ex. 57 | Ex. 58 | Ex. 59 | Ex. 60 |
|---|---|---|---|---|---|---|---|---|
| Layer constitution | | | | Surface laye/ internal layer/ surface layer=5%/90%/5% | Surface layer/ internal layer/ surface layer=5%/90%/5% | Surface layer/ internal layer/ surface layer=5%/90%/5% | Surface layer/ internal layer/ suface layer=5%90%/5% | Surface layer/ internal layer/ surface layer=5%/90%/5% |
| | Surface layer | Resin | | | | Ethylene-vinyl acetate copolymer | Ethylene-ethyl acrylate copolymer | Ethylene-ethyl acrylate copolymer |
| | | | Physical properties | | | VA=28 wt.%, MFR=5.7, mp=72˚C, Vicat 42˚C | Acrylate ester=18 wt%, MFR=2, mp=101˚C, Vicat 70˚C | Acrylate ester=16 wt%, MFR=1, mp=96˚C, Vicat 60˚C |
| | | | Ratio | | | 90 wt% | 50 wt% | 50 wt% |
| | | Saponified | | Saponified ethylene-vinyl acetate copolymer | Saponified ethylene-vinyl acetate copolymer | Saponified ethylene-vinyl acetate copolymer | Saponified ethylene-vinyl acetate copolymer | Saponified ethylene-vinyl acetate copolymer |
| | | resin | Physical properties | Saponification degree 40%, MFR=16, mp=100˚C, Vicat 51˚C | Saponification degree 40%, MFR=16, mp=100˚C, Vicat 47˚C | Saponification degree 40%, MFR=16, mp=100˚C, Vicat 51˚C | Saponification degree 40%, MFR=16, mp=100˚C, Vicat 51˚C | Saponification degree 40%, MFR=16, mp=100˚C, Vicat 51˚C |
| | | | Ratio | 100 wt% | 100 wt% | 10 wt% | 50 wt% | 50 wt% |
| | Internal layer | Resin | | Ethylene-vinyl acetate copolymer | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28 wt%, MFR=5.7, mp=72˚C | VA=28 wt%, MFR=5.7, mp=72˚C | VA=28 wt˚, MFR=5.7, mp=72˚C |
| Organic peroxide | | | | - | - | - | - | - |

39

(continued)

| | | | | | |
|---|---|---|---|---|---|
| | Bleeding ratio to sealing resin sheet | - | - | - | - | - |
| Coupling agent | | - | - | - | - | - |
| | Bleeding ratio to sealing resin sheet | - | - | - | - | - |
| Sheet thickness | | 450 μm | 450 μm | 450 μm | 450 μm | 450 μm |
| Cross-linking conditions | | No cure | No cure | No cure | No cure | No cure |
| | Apparatus | EPS-800 | EPS-800 | EPS-800 | EPS-800 | EPS-800 |
| | Acceleration voltage Irradiation density | 500kV | 500 kV | 500kV | 500kV | 500kV |
| | | 30 kGy | 30 kGy | 30 kGy | 30kGy | 30 kGy |
| Gel fraction | | | | | | |
| | All layer gel fraction (wt%) | 34 | 32 | 41 | 43 | 44 |
| Optical characteristics | | | | | | |
| | Haze (%) | 8.7 | 8.9 | 8.6 | 85 | 8.7 |
| | Total light transmittance (%) | 88 | 87 | 87 | 86 | 88 |
| Module evaluation | | | | | | |
| | Power generation surface member | Glass plate for solar cell (3 mm thick) | Glass plate for solar cell (3 mm thick) | Glass plate for solar cell (3 mm thick) | Glass plate for solar cell (3 mm thick) | Glass plat for solar cell (3 mm thick) |
| | Temperature humidity cycle | Appearance | ◎ | ◎ | ○ | ◎ | ◎ |
| | Storage stability evaluation | Peeling | ◎ | ◎ | ◎ | ◎ | ◎ |
| Adhesion strength to glass | N/10 mm with | 115 | 123 | 56 | 71 | 76 |
| High humidity | Storage at 23˚C-90% for one month | 110 | 125 | 60 | 67 | 75 |
| resistance test | | Almost no change | Almost no change | Almost no change | Almost no change | Almost no change |

[Table 17]

| | | | | Ex. 61 | Ex. 62 | Com. Ex. 13 | Com. Ex. 14 |
|---|---|---|---|---|---|---|---|
| Layer constitution | | | | Surface layer/ internal layer/ surface layer=5%/ 90%/50% | Surface layer/ internal layer=5%/90%/ 5% | Surface layer/ internal layer/ surface layer=5%/90%/ 5% | Surface layer/internal layer/ surface layer=5%/90/50% |
| | Surface layer | Resin | | | | Ethylene-vinyl acetate copolymer | Ethylene-vinyl acetate copolymer |
| | | | Physical properties | | | VA=28 wt%, MFR=5.7, mp=72˚C, Vicat 42˚C | VA=28 wt%, MFR=5.7, mp=72˚C, Vicat 42˚C |
| | | | Ratio | | | 100 wt% | 100 wt% |
| | | Saponified | | Saponified ethylene-vinyl acetate copolymer | Saponified ethylene-vinyl acetate copolymer | | |
| | | resin | Physical properties | Saponification degree 40%, MFR=5.5, mp=110˚C, Vicat 99˚C | Saponification degree=10%, MFR=6, mp=72˚C, Vicat 52˚C | | |
| | | | Ratio | 100 wt% | 100 wt% | | |
| | Internal layer | Resin | | Ethylene-vinyl acetate copolymer | Ethylene-vinyl acetate copolymer | Ethylene-vinyl acetate copolymer | Ethylene-vinyl acetate copolymer |
| | | | Physical properties | VA=28 wt%, MFR=5.7, mp=72˚C | VA=28 wt%, MFR=5.7, mp=72˚C | VA=28 wt%, MFR=5.7, mp=72˚C | VA=28 wt%, MFR=5.7, mp=72˚C |
| Organic peroxide | | | | - | - | - | 1,1-Bis(t-butylperoxy)3,3,5-trimethylcyclohexane |

(continued)

| | Ex. 61 | Ex. 62 | Com. Ex. 13 | Com. Ex. 14 |
|---|---|---|---|---|
| Coupling agent — Bleeding ratio to sealing resin sheet | - | - | - | 1.2 wt% |
| Coupling agent | - | - | - | γ-Chloropropyltrimethoxysilane 0.3 wt% |
| Bleeding ratio to sealing resin sheet | - | - | - | - |
| Sheet thickness | 450 μm | 450 μm | 450 μm | 450 μm |
| Cross-linking conditions | No cure | No cure | No cure | Cure conditions 150°C 60 min |
| Cross-linking conditions — Apparatus | EPS-800 | EPS-800 | EPS-800 | - |
| Acceleration voltage | 500 kV | 500 kV | 500 kV | - |
| Irradiation density | 30 kGy | 30 kGy | 30 kGy | - |
| Gel fraction — All layer gel fraction (wt%) | 35 | 33 | 41 | 83 |
| Optical characteristics — Haze (%) | 8.4 | 8.6 | 8.6 | 8.6 |
| Total light transmittance (%) | 90 | 89 | 87 | 87 |
| Module evaluation — Power generation surface member | Glass plate for solar cell (3 mm thick) | Glass plate for solar cell (3 mm thick) | Glass plate for solar cell (3 mm thick) | Glass plate for solar cell (3 mm thick) |
| Temperature humidity cycle — Appearance | ◎ | ◎ | ◎ | ◎ |
| Peeling | ◎ | ◎ | ◎ | ◎ |
| Storage stability evaluation | 112 | 121 | 23 | 92 |
| Adhesion strength to glass — N/10 mm width | 110 | 115 | 23 | 23 |
| High humidity resistance test — Storage at 23°C-90° for one month | Almost no change | Almost no change | Almost no change | Greatly reduced |

As shown in Tables 16 and 17, the sealing resin sheets of Examples 56 to 62 provided practically good evaluation results for the optical characteristics; when solar cell modules were prepared to perform temperature humidity cycle evaluation and storage stability evaluation, all of the modules provided good evaluation results. They were also excellent in the adhesion strength and high humidity resistance of the sealing resin sheets.

The resins used in the following Examples 63 to 69 were as follows.

(1) Ethylene-vinyl acetate copolymer
Ultracene 751 from Tosoh Corporation
(2) Saponified ethylene-vinyl acetate copolymer
Melthene 6410 from Tosoh Corporation
(3) Maleic acid-graft modified polyethylene
Admer SF751 from Mitsui Chemicals, Inc.
Admer NF518 from Mitsui Chemicals, Inc.
Admer XE070 from Mitsui Chemicals, Inc.
(4) Ultra-Low Density Polyethylene
EG8200 from The Dow Chemical Company
(5) Ethylene-glycidyl methacrylate-vinyl acetate copolymer (E-GMA-VA)
Bondfast 7B Grade from Sumitomo Chemical Co., Ltd.
(6) Ethylene-glycidyl methacrylate copolymer (E-GMA)
Bondfast E Grade from Sumitomo Chemical Co., Ltd.

Sealing resin sheets were produced using the materials and composition ratios shown in Table 18.
Certain resins were melted using two extruders (a surface layer extruder and an internal layer extruder); the resins were melt-extruded in the form of a tube through a ring die connected to the extruders; and the tube formed by the melt extrusion was quenched using a water cooling ring to provide sealing resin sheets shown in each of Examples 63 to 69. The resultant sealing resin sheets of Examples 63 to 69 were subjected to electron ray treatment according to the irradiation conditions shown in the Tables. The sealing resin sheets were evaluated for the all layer gel fraction, haze and total light transmittance rate. The results are shown in Table 18.
Solar cell modules were produced using the resultant sealing resin sheets, and their temperature humidity cycle and storage stability were evaluated. The evaluation results are shown in Table 18. Vacuum Laminator for Solar Cells Model LM50 from NPC was used as a vacuum laminator.

[Table 18]

| Layer constitution | | | | Ex 63 | Ex 64 | Ex 65 | Ex 66 | Ex 67 | Ex 68 | Ex 69 |
|---|---|---|---|---|---|---|---|---|---|---|
| | Surface layer | Resin | | Ethylene-vinyl acetate copolymer | Ultra-low density PE | Ultra-low density PE | Ethylene-vinyl acetate copolymer | Ultra-low density PE | | Ultra-low density PE |
| | | | Physical properties | VA=28 wt%, MFR=5.7, mp=72°C | MI=5, Density 0.87 | MI=5, Density 0.87 | VA=28 wt%, MFR=5.7, mp=72°C | MI=5, Density 0.87 | | MI=5, Density 0.87 |
| | | | Ratio | 95 wt% | 90 wt% | 90 wt% | 80 wt% | 80 wt% | | 80 wt% |
| | | Resin | | Maleic acid-grafted PE (Mitsui SF751) | Maleic acid-grafted PE (Mitsui NF518) | Maleic acid-grafted PE (Mitsui XE070) | E-GMA-VA (Sumitomo Chemical: 7B grade) | E-GMA-VA (Sumitomo Chemical: 7B grade) | E-GMA (Sumitomo Chemical: E grade) | E-GMA (Sumitomo Chemical: E grade) |
| | | | Physical properties | MFR=15, Density 0.906 | MFR=2.4, Density 0.911 | MFR=3, Density 0.893 | MFR=7, Density 0.950 | MFR=7, Density 0.950 | MFR=3, Density 0.940 | MFR=3, Density 0.940 |
| | | | Ratio | 5 wt% | 10 wt% | 10 wt% | 20 wt% | 20 wt% | 100 wt% | 20 wt% |
| | | Layer ratio | | 5% | 10% | 10% | 5% | 5% | 5% | 10% |
| | Internal layer | Resin | | Ethylene-vinyl acetate copolymer | Ethylene-vinyl acetate copolymer | Ultra-low density PE | Ethylene-vinyl acetate copolymer | Ultra-low density PE | Ultra-low density PE | Ultra-low density PE |
| | | | Physical properties | VA=28 wt%, MFR=5.7, mp=72°C | VA=28 wt%, MFR=5.7, mp=72°C | MI=1.6, Density 0.905 | VA=28 wt%, MFR=5.7, mp=72°C | MI=1.6, Density 0.905 | MI=1.6, Density 0.905 | MI=1.6, Density 0.905 |
| | | | Ratio | 95 wt% | 95 wt% | 100 wt% | 100 wt% | 100 wt% | 100 wt% | 100 wt% |
| | | Resin | | Saponified ethylene-vinyl acetate copolymer | | | | | | |
| | | | Physical properties | Saponification degree 40%, MFR=16, mp=100°C | | | | | | |
| | | | Ratio | 5 wt% | | | | | | |
| | | Layer ratio | | 90% | 80% | 80% | 90% | 90% | 90% | 80% |
| | Surface layer | Resin | | Ethylene-vinyl acetate copolymer | Ultra-low density PE | Ultra-low density PE | Ethylene-vinyl acetate copolymer | Ultra-low density PE | | Ultra-low density PE |
| | | | Physical properties | VA=28 wt%, MFR=5.7, mp=72°C | MI=5, Density 0.87 | MI=5, Density 0.87 | VA=28 wt%, MFR=5.7, mp=72°C | MI=5, Density 0.87 | | MI=5, Density 0.87 |
| | | | Ratio | 95 wt% | 90 wt% | 90 wt% | 80 wt% | 80 wt% | | 80 wt% |
| | | Resin | | Maleic acid-grafted PE (Mitsui SF751) | Maleic acid-grafted PE (Mitsui NF518) | Maleic acid-grafted PE (Mitsui XE070) | E-GMA-VA (Sumitomo Chemical: 7B grade) | E-GMA-VA (Sumitomo Chemical: 7B grade) | E-GMA (Sumitomo Chemical: E grade) | E-GMA (Sumitomo Chemical: E grade) |
| | | | Physical properties | MFR=15, Density 0.906 | MFR=2.4, Density 0.911 | MFR=3, Density 0.893 | MFR=7, Density 0.950 | MFR=7, Density 0.950 | MFR=3, Density 0.940 | MFR=3, Density 0.940 |
| | | | Ratio | 5 wt% | 10 wt% | 10 wt% | 20 wt% | 20 wt% | 100 wt% | 20 wt% |
| | | Layer ratio | | 5% | 10% | 10% | 5% | 5% | 5% | 10% |
| Organic peroxide | | | | | | | | | | |
| | Blending ratio to sealing resin sheet | | | - | - | - | - | - | - | - |
| Sheet thickness | | | | 450 μm | 450 μm | 450 μm | 450 μm | 450 μm | 450 μm | 450 μm |
| Irradiation conditions | | | | | | | | | | |
| | Apparatus | | | EPS-800 | EPS-800 | EPS-800 | EPS-800 | EPS-800 | EPS-800 | EPS-800 |
| | Acceleration voltage | | | 500 kV | 500 kV | 500 kV | 500 kV | 500 kV | 500 kV | 500 kV |
| | Irradiation density | | | 30 kGy | 30 kGy | 30 kGy | 30 kGy | 30 kGy | 30 kGy | 30 kGy |
| Gel fraction | | | | | | | | | | |
| | All layer gel fraction (%) | | | 41 | 41 | 21 | 45 | 41 | 23 | 25 |
| | Gel fraction of layer contacting material to be sealed (%) | | | 40 | 31 | 21 | 45 | 31 | 53 | 25 |
| Optical characteristics | | | | | | | | | | |
| | Haze (%) | | | 9.2 | 8.6 | 8.2 | 8.9 | 8.6 | 8.5 | 9.5 |
| | Total light transmittance (%) | | | 83 | 87 | 88 | 85 | 87 | 86 | 85 |
| Module evaluation | | | | | | | | | | |
| | Temperature humidity cycle | Appearance | | ○ | ○ | ○ | ○ | ○ | ○ | ○ |
| | Storage stability evaluation | Peeling | | ○ | ○ | ○ | ○ | ○ | ○ | ○ |

As shown in Table 18, the sealing resin sheets of Examples 63 to 69 provided practically good evaluation results for the optical characteristics; when solar cell modules were prepared to perform temperature humidity cycle evaluation and storage stability evaluation, all of the modules provided good evaluation results.

The present application is based on Japanese Patent Application No. 2008-224913 filed in the Japanese Patent Office September 2, 2008, Japanese Patent Application No. 2008-101116 filed in the Japanese Patent Office April 9, 2008, and Japanese Patent Application No. 2008-174366 filed in the Japanese Patent Office July 3, 2008, the contents of which are incorporated herein by reference.

Industrial Applicability

The sealing resin sheet of the present invention has industrial applicability as a sealer for protecting various elements such as a semiconductor device for solar cells and the like.

**Claims**

1. A sealing resin sheet for allowing a resin layer in a softened state to adhere to and seal a material to be sealed, wherein the resin layer comprises an adhesive resin.

2. The sealing resin sheet according to claim 1, wherein the adhesive resin comprises at least one resin selected from the group consisting of an olefin-based copolymer having a hydroxyl group, a modified polyolefin terminal- or graft-modified with an acidic functional group, and an ethylene copolymer containing glycidyl methacrylate.

3. The sealing resin sheet according to claim 2, wherein the olefin-based copolymer having the hydroxyl group is a saponified ethylene-vinyl acetate copolymer and/or a saponified ethylene-vinyl acetate-acrylate ester copolymer.

4. The sealing resin sheet according to claim 2 or 3, wherein the modified polyolefin terminal- or graft-modified with the acidic functional group is a maleic modified polyolefin terminal- or graft-modified with maleic anhydride.

5. The sealing resin sheet according to any one of claims 1 to 4, wherein the resin layer comprises at least one thermoplastic resin selected from the group consisting of an ethylene-vinyl acetate copolymer, an ethylene-aliphatic unsaturated carboxylic acid copolymer, an ethylene-aliphatic carboxylate ester copolymer, and a polyolefin-based resin.

6. The sealing resin sheet according to any of claims 1 to 5, wherein a content of the adhesive resin in the resin layer is 10 to 100% by mass.

7. The sealing resin sheet according to any one of claims 1 to 6, wherein a content of the thermoplastic resin in the resin layer is 0 to 90% by mass.

8. The sealing resin sheet according to any one of claims 1 to 7, wherein the sheet has a single layer structure consisting of only the resin layer comprising an adhesive resin.

9. The sealing resin sheet according to claim 8, wherein the resin layer has a gel fraction of 1 to 65% by mass.

10. The sealing resin sheet according to claim 8 or 9, wherein the resin layer has a graded cross-linked structure.

11. The sealing resin sheet according to any one of claims 1 to 7, wherein the sheet has a multilayer structure of at least two layers comprising a surface layer and an internal layer laminated on the surface layer, wherein at least one of the surface layer is the resin layer comprising an adhesive resin.

12. The sealing resin sheet according to claim 11, wherein the at least one of the surface layer has a gel fraction of 1 to 65% by mass.

13. The sealing resin sheet according to claim 11 or 12, wherein the sheet has a moisture vapor transmission rate of 40 g/m$^2$·day or less.

14. The sealing resin sheet according to any one of claims 1 to 13, wherein the sheet is obtained by film formation using a ring die.

15. The sealing resin sheet according to any one of claims 1 to 14, wherein the sheet is used as a sealer for protecting a member of a solar cell.

16. The sealing resin sheet according to any one of claims 1 to 14, wherein the sheet is used as an interlayer of a laminated glass.

## INTERNATIONAL SEARCH REPORT

| International application No. |
| --- |
| PCT/JP2009/056342 |

A. CLASSIFICATION OF SUBJECT MATTER
*C08J5/18*(2006.01)i, *C08J7/00*(2006.01)i, *C08K5/00*(2006.01)i, *C08L23/04*(2006.01)i, *H01L23/29*(2006.01)i, *H01L23/31*(2006.01)i, *H01L31/04*(2006.01)i

According to International Patent Classification (IPC) or to both national classification and IPC

B. FIELDS SEARCHED

Minimum documentation searched (classification system followed by classification symbols)
C08J5/18, C08J7/00, C08K5/00, C08L23/04, H01L23/29, H01L23/31, H01L31/04

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2005-203577 A  (Mitsubishi Heavy Industries, Ltd.), 28 July, 2005 (28.07.05), Claims (Family: none) | 1,5-16 |
| X | JP 2002-151710 A  (Kaneka Corp.), 24 May, 2002 (24.05.02), Claims; Par. Nos. [0019], [0020] (Family: none) | 1,5-16 |
| X | JP 11-261085 A  (Mitsubishi Plastics, Inc.), 24 September, 1999 (24.09.99), Claim 6; Par. Nos. [0010], [0019], [0020]; example 5 (Family: none) | 1-16 |

☒ Further documents are listed in the continuation of Box C.　　☐ See patent family annex.

| | |
| --- | --- |
| *　　Special categories of cited documents:<br>"A"　document defining the general state of the art which is not considered　to be of particular relevance<br>"E"　earlier application or patent but published on or after the international filing date<br>"L"　document which may throw doubts on priority claim(s) or which is cited to establish the publication date of another citation or other special reason (as specified)<br>"O"　document referring to an oral disclosure, use, exhibition or other means<br>"P"　document published prior to the international filing date but later than the priority date claimed | "T"　later document published after the international filing date or priority date and not in conflict with the application but cited to understand the principle or theory underlying the invention<br>"X"　document of particular relevance; the claimed invention cannot be considered novel or cannot be considered to involve an inventive step when the document is taken alone<br>"Y"　document of particular relevance; the claimed invention cannot be considered to involve an inventive step when the document is combined with one or more other such documents, such combination being obvious to a person skilled in the art<br>"&"　document member of the same patent family |

| Date of the actual completion of the international search<br>　10 June, 2009 (10.06.09) | Date of mailing of the international search report<br>　23 June, 2009 (23.06.09) |
| --- | --- |
| Name and mailing address of the ISA/<br>　Japanese Patent Office | Authorized officer |
| Facsimile No. | Telephone No. |

Form PCT/ISA/210 (second sheet) (April 2007)

**EP 2 270 077 A1**

### INTERNATIONAL SEARCH REPORT

| | International application No. |
|---|---|
| | PCT/JP2009/056342 |

C (Continuation).   DOCUMENTS CONSIDERED TO BE RELEVANT

| Category* | Citation of document, with indication, where appropriate, of the relevant passages | Relevant to claim No. |
|---|---|---|
| X | JP 8-283696 A  (Haishito Kogyo Kabushiki Kaisha), 29 October, 1996 (29.10.96), Claims; Par. No. [0032] (Family: none) | 1,5-16 |
| X | JP 2001-119047 A  (Du Pont-Mitsui Polychemicals Co., Ltd.), 27 April, 2001 (27.04.01), Claims; Par. No. [0016]; examples (Family: none) | 1,5-16 |
| X | JP 60-137075 A  (Takeda Chemical Industries, Ltd.), 20 July, 1985 (20.07.85), Claims; pages 2 to 3; examples & US 4614781 A          & EP 145928 A3 & CA 1226097 A          & KR 10-1992-0004617 B | 1-8,11,13-16 |
| X | JP 8-148708 A  (Sekisui Chemical Co., Ltd.), 07 June, 1996 (07.06.96), Par. No. [0007]; comparative example 5 (Family: none) | 1-8,11,13-16 |
| X | JP 6-334207 A  (Canon Inc.), 02 December, 1994 (02.12.94), Example 2 (Family: none) | 1-8,11,13-16 |

Form PCT/ISA/210 (continuation of second sheet) (April 2007)

48

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001119047 A
- JP 6334207 A
- JP 8283696 A
- JP 2008224913 A
- JP 2008101116 A
- JP 2008174366 A